(19) Europäisches Patentamt
European Patent Office
Office européen des brevets

(11) **EP 3 570 398 B1**

(12) **EUROPEAN PATENT SPECIFICATION**

(45) Date of publication and mention
of the grant of the patent:
**25.05.2022 Bulletin 2022/21**

(21) Application number: **19170162.2**

(22) Date of filing: **18.04.2019**

(51) International Patent Classification (IPC):
**H02H 1/00** *(2006.01)*   **H02H 3/38** *(2006.01)*

(52) Cooperative Patent Classification (CPC):
**H02H 3/385; H02H 1/0015**

(54) **METHOD AND APPARATUS FOR DETERMINING A DIRECTION OF AN INTERMITTENT GROUNDING FAULT IN A POWER GRID**

VERFAHREN UND VORRICHTUNG ZUM BESTIMMEN DER RICHTUNG EINES INTERMITTIERENDEN ERDUNGSFEHLERS IN EINEM STROMNETZ

PROCÉDÉ ET APPAREIL PERMETTANT DE DÉTERMINER UNE DIRECTION D'UN DÉFAUT DE MISE À LA TERRE INTERMITTENT DANS UN RÉSEAU ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.04.2018 CN 201810367195**

(43) Date of publication of application:
**20.11.2019 Bulletin 2019/47**

(73) Proprietor: **Siemens Aktiengesellschaft
80333 München (DE)**

(72) Inventors:
• **WERBEN, Stefan**
  **91207 Lauf a. d. P. (DE)**
• **LIAN, Hai Tao**
  **Nanjing, Jiangsu 211100 (CN)**
• **WANG, Long Tian**
  **Nanjing, Jiangsu 211100 (CN)**
• **CHEN, Xiao Xiang**
  **Nanjing, Jiangsu 210000 (CN)**
• **GUO, Jin Ning**
  **Nanjing, Jiangsu 210000 (CN)**

(74) Representative: **Patentanwaltskanzlei WILHELM & BECK
Prinzenstraße 13
80639 München (DE)**

(56) References cited:
**US-A1- 2012 123 708    US-A1- 2016 061 873
US-A1- 2018 011 135**

**Description**

Technical Field

The present invention relates to the field of electrical network technologies, and in particular, to a method and an apparatus for determining a direction of an intermittent grounding fault in a power grid.

Background Art

Whether electric distribution networks operate safely and reliably is exerting more and more significant influences on the economy and social life. As extra efforts have been made in the transformation of urban power grids and rural power grids and the urban modernization has advanced rapidly, underground cables have been widely used, and capacitance currents in electric distribution networks systems have increased. If a cable is dampened or water seeps into it, a short circuit may occur due to a decrease in the insulation of the cable. Within a short time after a short-circuit current is generated, the cable will quickly bounce and be isolated from the fault due to stress, and the short-circuit current will disappear. However, the cable remains in an unsafe operating state, and faults keep occurring intermittently. In a non-grounded neutral system, the overvoltage caused by intermittent arc grounding is high and lasts for a long time, which may jeopardize the insulation of the equipment and even cause an inter-phase short circuit. Such faults have a shock action and occur intermittently. This phenomenon is known as an intermittent grounding fault.

Intermittent grounding faults contain many transients in a zero-sequence system, and such transients exhibit different characteristics. Therefore, it is difficult to determine directions of intermittent grounding faults. Specifically, if an intermittent grounding fault is located in a power line protected by the present segment, the direction of the intermittent grounding fault is determined to be forward; if the intermittent grounding fault is not located in the power line, the direction of the intermittent grounding fault is determined to be backward. Incorrect direction determination may result in insufficiency or excess of function, and consequently the main equipment may be damaged or a properly working line is tripped out.

In the prior art, directions of intermittent grounding faults are generally determined on the basis of phase angles between zero-sequence voltages of zero-sequence currents in an electric distribution network. However, since the transient durations of zero-sequence currents and zero-sequence voltages are indeterminate, fault directions determined by this method are not accurate.

Document US 2012/123708 A1 informs about a method and a system for transient and intermittent earth fault detection and direction determination in a three-phase median voltage electric power distribution system which comprises: sampling means, transient direction detection means, random intermittent detection means, means of integrating transient direction and random intermittent detection and alarm means.

Document US 2016/061873 A1 discloses a method for detecting and locating faulty line on the distribution network circuit based on full waveform information, which uses the current data on the fault occurrence and whole-process operation of the compensation device to effectively solve such common problems as low fault current, poor reliability and low sensitivity in case of single-phase grounding fault to the low-current system through precise GPS synchronization.

Document US 2018/011135 A1 informs about a method for ascertaining an earth fault and the earth-fault direction in a three-phase network which is operated in a compensated manner or in an insulated manner. Value pairs of a zero voltage and a zero current are measured, the active or reactive energy is calculated, and a voltage flag and a current flag are combined by a Boolean link, wherein the presence of an earth fault is ascertained depending on the result, and a decision is made as to whether the earth-fault direction is signalled as "forward" or "reverse" at least on the basis of the sign of the active or reactive energy.

Summary of the Invention

The present invention provides a method and an apparatus for determining a direction of an intermittent grounding fault in a power grid, as defined by the independent claims 1 and 8.

The present invention provides the following technical solution: a method for determining a direction of an intermittent grounding fault in a power grid, comprising:

if an effective value of a zero-sequence current of a power line of a power grid is greater than or equal to a predetermined threshold, determining the maximum value point of the zero-sequence current;
determining the sign of the maximum variation increment of the zero-sequence voltage corresponding to the maximum value point; and
comparing the sign of the maximum variation increment with the sign of a zero-sequence current at the maximum value point and, based on a comparison result, determining whether the intermittent grounding fault is located in the power line.

Thus, the present invention determines a direction of an intermittent grounding fault based on a result of comparison between the sign of the maximum zero-sequence current value and the sign of the maximum variation increment of the zero-sequence voltage corresponding to the maximum value, without the need of capturing the transients of zero-sequence voltage whose duration is indeterminate, thereby improving the accuracy of the fault direction determination.

In an embodiment, said comparing the sign of the maximum variation increment with the sign of the zero-sequence current at the maximum value point and, based on a comparison result, determining whether the intermittent grounding fault is located in the power line comprises: if the sign of the maximum variation increment is the same as a sign of the zero-sequence current at the maximum value point, determining that the intermittent grounding fault is located in the power line; and if the sign of the maximum variation increment is opposite to the sign of the zero-sequence current at the maximum value point, determining that the intermittent grounding fault is not located in the power line.

It is thus clear that the present invention allows the direction of an intermittent grounding fault to be determined on the basis of whether the sign of the zero-sequence current at the maximum value point and the sign of the maximum variation increment are the same, and the implementation process is simple.

In an embodiment, said determining the maximum value point of the zero-sequence current comprises: determining a plurality of maximum value points of the zero-sequence current in a search area; said determining the sign of the maximum variation increment of the zero-sequence voltage corresponding to the maximum value point comprises: determining a sign of each maximum variation increment of the plurality of zero-sequence voltages corresponding to the plurality of maximum value points; said comparing the sign of the maximum variation increment with the sign of the zero-sequence current at the maximum value point and, based on the comparison result, determining whether the intermittent grounding fault is located in the power line comprises: if any signs of the maximum variation increments are the same as the signs of the zero-sequence currents at the maximum value points and the number of the same signs satisfies a first preset rule, determining that the intermittent grounding fault is located in the power line; and if any signs of the maximum variation increments are opposite to the signs of the zero-sequence currents at the maximum value points and the number of opposite signs satisfies a second preset rule, determining that the intermittent grounding fault is not located in the power line.

It is thus clear that the present invention improves the accuracy of determining directions of intermittent grounding faults by determining whether the sign of the zero-sequence current at the maximum value point and the sign of the maximum variation increment are the same and continuous.

In an embodiment, the first preset rule comprises: the signs of M consecutive maximum variation increments are the same as the signs of the zero-sequence currents at corresponding maximum value points, wherein M is an integer greater than or equal to 2;

the second preset rule comprises: the signs of N consecutive maximum variation increments are opposite to the signs of the zero-sequence currents at corresponding maximum value points, wherein N is an integer greater than or equal to 2.

Therefore, the present invention proposes preset rules that are simple and easy to follow for determining directions of intermittent grounding faults.

In an embodiment, before comparing the sign of the maximum variation increment with the sign of the zero-sequence current at the maximum value point, the method further comprises: determining a time interval difference between two adjacent maximum value points and, when the time interval difference is smaller than a predetermined interval difference threshold, discarding the latter of the two adjacent maximum value points.

Therefore, an embodiment of the present invention detects time interval differences between adjacent maximum value points and discards invalid maximum value points to avoid repeated detections of a fault, thereby improving the accuracy of determining the direction of an intermittent grounding fault.

In an embodiment, said determining a maximum value point of the zero-sequence current comprises:

from the starting point of a cycle of the time at which the effective value of the zero-sequence current of the power line is greater than the predetermined threshold, determining the rise starting point of the zero-sequence current; determining the peak value of the zero-sequence current from the rise starting point of the zero-sequence current; and determining a current point corresponding to the peak value as the maximum value point.

Therefore, an embodiment of the present invention determines the maximum value point of the zero-sequence current based on the rise starting point of the zero-sequence current so that the maximum value point of the zero-sequence current can be quickly determined, thereby increasing the system response speed.

In an embodiment, said determining the rise starting point of the zero-sequence current comprises: determining whether the zero-sequence current of the power line satisfies a first predetermined condition, and if yes, determining that the zero-sequence current of the power line is a rise starting point; the first predetermined condition comprises: a sampled value of the zero-sequence current is greater than the product of the effective value and a first predetermined factor, and the current value of the zero-sequence current is greater than the product of a rated secondary current value of the power grid and a second predetermined factor, the first predetermined factor being greater than 1 and the second predetermined factor being smaller than 1.

Therefore, an embodiment of the present invention searches the rise starting point of the zero-sequence current based on a rated secondary current value and the effective value to quickly determine the rise starting point of the zero-sequence current, thereby further increasing the system response speed.

In an embodiment, the first predetermined factor is 2 and the second predetermined factor is 5%.

In an embodiment, said determining the sign of the maximum variation increment of the zero-sequence voltage corresponding to the maximum value point comprises:

obtaining a first first-derivative function of the zero-sequence voltage and time;
obtaining a second first-derivative function of the zero-sequence voltage and time of the previous cycle;
determining a difference function between the first first-derivative function and the second first-derivative function; and

within a predetermined time area of the maximum value point, determining the maximum value point of the absolute value of the difference function, and determining the sign of the difference function value at the maximum value point as the sign of the maximum variation increment.

Therefore, an embodiment of the present invention can quickly determine the sign of the maximum variation increment of the zero-sequence voltage at the maximum value point with the simple calculation process of the difference function.

In an embodiment, after determination of the sign of the maximum variation increment, and before comparing the sign of the maximum variation increment with the sign of the zero-sequence current at the maximum value point, the method further comprises:

determining whether the absolute value of the maximum variation increment is greater than or equal to a predetermined variation increment threshold, and if no, discarding the maximum variation increment and determining that the direction of the intermittent grounding fault is undetermined.

Therefore, an embodiment of the present invention, by discarding maximum variation increments smaller than a predetermined variation increment threshold, identifies intermittent grounding faults whose fault directions are undeterminable, thereby reducing the probability of errors in determining the directions of intermittent grounding faults.

In an embodiment, after determination of the sign of the maximum variation increment, and before comparing the sign of the maximum variation increment with the sign of the zero-sequence current at the maximum value point, the method further comprises:

determining whether the absolute value of the maximum variation increment is greater than or equal to a predetermined variation increment threshold, and if yes, comparing the sign of the maximum variation increment with the sign of the zero-sequence current at the maximum value point.

Thus, an embodiment of the present invention ensures that an intermittent grounding fault whose direction is determinable will be subjected to subsequent direction detection operations.

In an embodiment, the variation increment threshold is A;

$$A = x\% * U_{rated};$$

wherein $U_{rated}$ indicates the secondary rated voltage value of the power grid; x is a predetermined constant.

Therefore, an embodiment of the present invention determines a variation increment threshold based on a secondary rated voltage value and a time increment, thereby improving the reliability of the variation increment threshold.

In an embodiment, x is equal to 3.

An apparatus for determining a direction of an intermittent grounding fault in a power grid comprises:

a maximum value point determination module, configured to, if an effective value of a zero-sequence current of a power line of a power grid is greater than or equal to a predetermined threshold, determine a maximum value point of the zero-sequence current;
a sign determination module, configured to determine a sign of a maximum variation increment of the zero-sequence voltage corresponding to the maximum value point; and
a comparison module, configured to compare the sign of the maximum variation increment with the sign of the zero-sequence current at the maximum value point and, based on the comparison result, determine whether the intermittent grounding fault is located in the power line.

Thus, an embodiment of the present invention determines the direction of an intermittent grounding fault based on the result of a comparison between the sign of the maximum zero-sequence current value and the sign of the maximum variation increment of the zero-sequence voltage corresponding to the maximum value, without the need of capturing the transients of zero-sequence voltage whose duration is indeterminate, thereby improving the accuracy in determining the direction of a fault.

In an embodiment, said comparing, by the comparison module, the sign of the maximum variation increment with the sign of the zero-sequence current at the maximum value point and, based on the comparison result, determining whether the intermittent grounding fault is located in the power line comprises: if the sign of the maximum variation increment is the same as the sign of the zero-sequence current at the maximum value point, determining that the intermittent grounding fault is located in the power line; and if the sign of the maximum variation increment is opposite to the sign of the zero-sequence current at the maximum value point, determining that the intermittent grounding fault is not located in the power line.

It is thus clear that the present invention allows the direction of an intermittent grounding fault to be determined on the basis of whether the sign of the zero-sequence current at the maximum value point and the sign of the maximum variation increment are the same, and the implementation process is simple.

In an embodiment, the maximum value point determination module is configured to determine a plurality of maximum value points of the zero-sequence current in a search area; the comparison module is configured to, if any signs of the maximum variation increments are the same as the signs of the zero-sequence currents at the maximum value points and the number of the same signs satisfies a first preset rule, determine that the intermittent grounding fault is located in the power line, and if any signs of the maximum variation increments are opposite to the signs of zero-sequence currents at the maximum value points and the number of opposite signs satisfies a second preset rule, determine that the intermittent grounding fault is not located in the power line.

It is thus clear that the present invention improves the accuracy of determining the direction of an intermittent grounding fault by determining whether the sign of the zero-sequence current at the maximum value point and the sign of the maximum variation increment are the same and continuous.

In an embodiment, the first preset rule comprises: the signs of M consecutive maximum variation increments are the same as the signs of the zero-sequence currents at corresponding maximum value points, wherein M is an integer greater than or equal to 2;

the second preset rule comprises: the signs of N consecutive maximum variation increments are opposite to the signs of the zero-sequence currents at corresponding maximum value points, wherein N is an integer greater than or equal to 2.

Therefore, the present invention proposes preset rules that are simple and easy to follow for determining the direction of an intermittent grounding fault.

In an embodiment, the maximum value point determination module is further configured to, before the comparison module compares the sign of the maximum variation increment with the sign of the zero-sequence current at the maximum value point, determine a time interval difference between two adjacent maximum value points, and, if the time interval difference is smaller than a predetermined interval difference threshold, discard the latter of the two adjacent maximum value points.

Therefore, the present invention detects time interval differences between adjacent maximum value points and discards invalid maximum value points to avoid repeated detections of a fault, thereby improving the accuracy of determining the direction of an intermittent grounding fault.

In an embodiment, the maximum value point determination module is configured to, from the starting point of a cycle of the time at which the effective value of the zero-sequence current of the power line is greater than the predetermined threshold, determine the rise starting point of the zero-sequence current; determine the peak value of the zero-sequence current from the rise starting point of the zero-sequence current; and determine the current point corresponding to the peak value as the maximum value point.

Therefore, the present invention determines the maximum value point of the zero-sequence current based on the rise starting point of the zero-sequence current so that the maximum value point of the zero-sequence current can be quickly determined, thereby increasing the system response speed.

In an embodiment, the maximum value point determination module is configured to determine whether the zero-sequence current of the power line satisfies a first predetermined condition, and if yes, determine that the zero-sequence current of the power line is the rise starting point; the first predetermined condition comprises: a sampled value of the zero-sequence current is greater than the product of the effective value and a first predetermined factor, and the current value of the zero-sequence current is greater than the product of a rated secondary current value of the power grid and a second predetermined factor, the first predetermined factor being greater than 1 and the second predetermined factor being smaller than 1.

Therefore, the present invention searches the rise starting point of the zero-sequence current based on a rated secondary current value and the effective value to quickly determine the rise starting point of the zero-sequence current, thereby further increasing the system response speed.

In an embodiment, the sign determination module is configured to obtain a first first-derivative function of the zero-sequence voltage and time; obtain a second first-derivative function of the zero-sequence voltage and time of the previous cycle; determine a difference function between the first first-derivative function and the second first-derivative function; and within a predetermined time area of the maximum value point, determine the maximum value point of the absolute value of the difference function, and determine the sign of the difference function value at the maximum value point as the sign of the maximum variation increment.

Therefore, the present invention can quickly determine the sign of the maximum variation increment of the zero-sequence voltage at the maximum value point with a simple calculation process of the difference function.

In an embodiment, the comparison module is further configured to, after the sign determination module determines the sign of the maximum variation increment and before comparing the sign of the maximum variation increment with the sign of the zero-sequence current at the maximum value point, determine whether the absolute value of the maximum variation increment is greater than or equal to a predetermined variation increment threshold, and if no, discard the maximum variation increment and determine that the direction of the intermittent grounding fault is undetermined.

Therefore, an embodiment of the present invention, by discarding maximum variation increments smaller than a predetermined variation increment threshold, identifies intermittent grounding faults whose fault directions are undeterminable, thereby reducing the probability of errors in determining the directions of intermittent grounding faults.

In an embodiment, the comparison module is further configured to, after determination of the sign of the maximum variation increment and before comparison of the sign of the maximum variation increment with the sign of the zero-sequence current at the maximum value point, determine whether the absolute value of the maximum variation increment is greater than or equal to a predetermined variation increment threshold, and if yes, compare the sign of the maximum variation increment with the sign of the zero-sequence current at the maximum value point.

Thus, an embodiment of the present invention ensures that an intermittent grounding fault whose direction is determinable will be subjected to subsequent direction detection operations.

In an embodiment, the variation increment threshold is A;

$$A = x\% * U_{rated};$$

wherein $U_{rated}$ indicates the secondary rated voltage value of the power grid; x is a predetermined constant.

An apparatus for determining a direction of an intermittent grounding fault in a power grid comprises a processor and a memory;

the memory stores an application executable by the processor for causing the processor to perform the steps of the method for determining a direction of an intermittent grounding fault in a power grid as described in any one of the embodiments above.

Therefore, an embodiment of the present invention further discloses an apparatus that, based on a processor and a memory, determines a direction of an intermittent grounding fault in a power grid, the processor being capable of performing the steps of a method for determining a direction of an intermittent grounding fault in a power grid.

A computer-readable storage medium stores computer-readable instructions for performing the steps of the method for determining a direction of an intermittent grounding fault in a power grid as described in any one of the embodiments above.

Therefore, an embodiment of the present invention further discloses a computer-readable storage medium for storing computer-readable instructions that are executable to perform the steps of a method for determining a direction of an intermittent grounding fault in a power grid.

Brief Description of the Drawings

Figure 1 is a flowchart of a method for determining a direction of an intermittent grounding fault in a power grid according to an embodiment of the present invention;

Figure 2 is a flowchart of an exemplary method for determining a direction of an intermittent grounding fault in a power grid according to an embodiment of the present invention;

Figure 3 is a schematic diagram for a zero-sequence current pulse generated when a single-phase fault occurs before current restrike according to an embodiment of the present invention;

Figure 4 is a schematic diagram for the zero-sequence voltage pulse shown in Figure 3;

Figure 5 is a schematic diagram for a first-derivative function of the zero-sequence voltage shown in Figure 3;

Figure 6 is a schematic diagram for a difference function between a first-derivative function of the zero-sequence voltage shown in Figure 3 and a first-derivative function of a zero-sequence voltage of the previous cycle;

Figure 7 is a schematic diagram for a zero-sequence current pulse generated when current restrike occurs during a single-phase fault according to an embodiment of the present invention;

Figure 8 is a schematic diagram for a zero-sequence voltage pulse generated when current restrike occurs during a single-phase fault according to an embodiment of the present invention;

Figure 9 is a structural diagram for an apparatus for determining a direction of an intermittent grounding fault in an electric distribution network according to an embodiment of the present invention;

Figure 10 is a structural diagram for an apparatus for determining a direction of an intermittent grounding fault in an electric distribution network according to an embodiment of the present invention.

The reference numerals used in the drawings are listed in the following table:

| Reference numeral | Meaning |
| --- | --- |
| 102~108 | Steps |
| 201~209 | Steps |
| 900 | Apparatus for determining a direction of an intermittent grounding fault in a power grid |
| 901 | Maximum value point determination module |
| 902 | Sign determination module |
| 903 | Comparison module |
| 1000 | Apparatus for determining a direction of an intermittent grounding fault in a power grid |
| 1001 | Memory |
| 1002 | Processor |

Specific Embodiments

In order to allow a better understanding of the technical solution and benefits of the present invention, the present invention will be further described in detail below with reference to the attached drawings and embodiments. It should be understood that the specific embodiments described herein are merely illustrative of the present invention, instead of limiting the scope of the present invention.

For brevity and clarity, the technical solution of the present invention are explained below by describing several typical embodiments. The details given about the embodiments are only intended to help understand the technical solutions of the present invention. However, apparently, implementation of the technical solution of the present invention is not limited to these details. In order to avoid any unnecessary obscuring of the technical solution of the present invention, some embodiments, instead of being described in detail, are simply outlined. In the following text, "comprising" means "comprising but not limited to", and "according to..." means "at least according to ..., but not only according to...". The number of a component, unless otherwise specified, may be one or more, or may be understood as at least one.

First, the concept of a direction of an intermittent grounding fault of a power line is explained. If an intermittent grounding fault is located in the power line, the direction of the intermittent grounding fault is determined to be forward; if the intermittent grounding fault is not located in the power line, for example, being located in another power line in the power grid, the direction of the intermittent grounding fault is determined to be reverse.

In the prior art, since the transient durations of a zero-sequence current and a zero-sequence voltage are not fixed, the accuracy of determining directions of intermittent grounding faults is not high. An embodiment of the present invention, without the need of capturing transients of zero-sequence voltages, provides a solution for determining a direction of an intermittent grounding fault with high accuracy based on a comparison between the sign of the maximum zero-sequence current value and the sign of the maximum variation increment of the zero-sequence voltage near the maximum value.

In an embodiment of the present invention, first, the maximum value point of the zero-sequence current ($3I_0$) is found; then, the maximum variation increment of the zero-order voltage near the maximum value point for the first derivative of time is searched, and the sign of the maximum value point is compared with the sign of the maximum variation increment to determine the direction of the intermittent grounding fault.

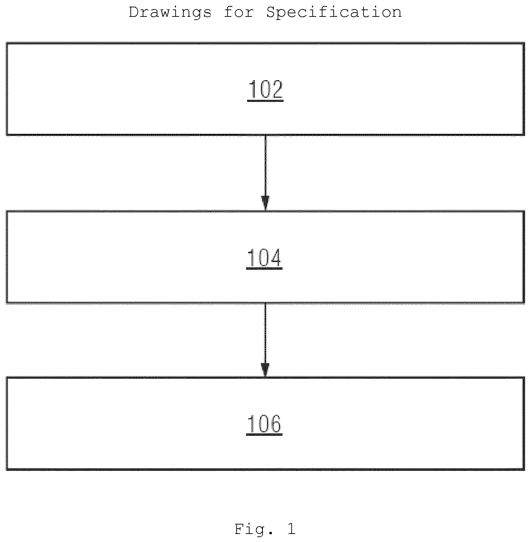

Figure 1 is a flowchart of a method for determining a direction of an intermittent grounding fault in a power grid according to an embodiment of the present invention.

As shown in Figure 1, the method comprises:

Step 102: If an effective value of a zero-sequence current of a power line of a power grid is greater than or equal to a predetermined threshold, determine the maximum value point of the zero-sequence current.

When the effective value, that is, the Root Mean Square (RMS) value, of the zero-sequence current of a power line is greater than a predetermined threshold, whether an intermittent grounding fault has occurred needs to be determined; when the direction of the intermittent grounding fault is determined, whether an intermittent grounding fault has occurred in the power line is determined. When the maximum value point of a zero-sequence current is determinable, it is determined that an intermittent grounding fault has occurred, and then the fault direction is determined on the basis of the maximum value point of the zero-sequence current.

Optionally, the process of determining a maximum value point of a zero-sequence current comprises: from the starting point of a cycle of the time at which the effective value of the zero-sequence current of the power line is greater than a predetermined threshold, determining the rise starting point of the zero-sequence current; determining the peak value of the zero-sequence current from the rise starting point of the zero-sequence current; and determining a current point corresponding to the peak value as the maximum value point.

Specifically, a search area may be started when the effective value of the zero-sequence current of the power line is greater than or equal to the predetermined threshold, and the length of a search area may be a preset value (for example, a length comprising one or more cycles) or a variable value.

For example, if it is judged that the zero-sequence current satisfies the following first predetermined condition, then the time period from the start point of the cycle to the time when the zero-sequence current is judged to satisfy the first predetermined condition is taken as the search area. The first predetermined condition is that the length of time when the effective value of the zero-sequence current is smaller than the predetermined threshold exceeds a predetermined length of time. In the search area, a rise starting point of a zero-sequence current that satisfies a second predetermined condition is determined; from the rise starting point of the zero-sequence current, the peak value of the zero-sequence current is searched, wherein the peak value can be understood as the peak value of the absolute value; the point of the peak is determined as the maximum value point of the zero-sequence current. The second predetermined condition may comprise: the zero-sequence current value is greater than a product of the effective value and a first predetermined factor, and the zero-sequence current value is greater than a product of the rated secondary current value of the power grid and a second predetermined factor. Optionally, the first predetermined factor is set to 2 and the second predetermined factor is set to 5%. Based on the second predetermined condition, an accurate rise starting point of the zero-sequence current can be obtained, and no unstable current point will be determined as a rise starting point of the zero-sequence current.

Typical values of the first predetermined factor and the second predetermined factor are exemplified above, and those of ordinary skill in the art will appreciate that the description is merely exemplary and is not intended to limit the scope of the embodiments of the present invention. Further, the typical process for determining a maximum value point of a zero-sequence current is exemplified above, and those of ordinary skill in the art will appreciate that the description is also merely exemplary and is not intended to limit the scope of the embodiments of the present invention.

Optionally, after detection of the predetermined time interval of a maximum value point of the zero-sequence current, a maximum value point of the zero-sequence current is detected again, and the time interval difference between the two adjacent maximum value points is determined; if the time interval difference is smaller than a predetermined interval difference threshold, the latter of the two adjacent maximum value points is discarded. Specifically, first, a time interval difference between a maximum value point of the zero-sequence current detected again and an adjacent maximum value point of the previously detected zero-sequence current is calculated; then, if it is determined that the time interval difference is smaller than the predetermined interval difference threshold, it is judged that the maximum value of the zero-sequence current detected again (that is, the latter maximum value point) is an invalid point, and the invalid point is discarded. With the above-mentioned process of judging an invalid point, repeated detections of a fault is avoided, and the accuracy of determining a direction of an intermittent grounding fault is improved.

For example, assume an interval difference threshold of 20 milliseconds and a search area of 40 milliseconds. The first zero-sequence current maximum value point is retrieved on the basis of the predetermined condition at the 5th millisecond, and the second zero-sequence current maximum value point is also retrieved on the basis of the predetermined condition at the 24th millisecond. The time interval difference between the second zero-sequence current maximum value point and the first zero-sequence current maximum value point is (24 - 5) milliseconds, that is, 19 milliseconds. For an intermittent grounding fault, zero-sequence current maximum value points do not occur for multiple times within a short period of time. Since the time interval difference between the two zero-sequence current maximum value points is too small, that is, smaller than the interval difference threshold (20 milliseconds), the second zero-sequence current maximum value point is judged to be invalid.

The above-mentioned specific values of the interval difference threshold and the search area are merely exemplary and are not intended to limit the scope of embodiments of the present invention.

Step 104: Determine the sign of a maximum variation increment of the zero-sequence voltage of the power line corresponding to the maximum value point.

For example, the time corresponding to the maximum value point is the first point in time, and the time corresponding to the maximum variation increment of the corresponding zero-sequence voltage is the second point in time; the second point in time is located in a predetermined time zone near the first point in time; in other words, it may be the same time as the first point in time, or there may be very little difference in time.

This step may specifically comprise: obtaining a first first-derivative function of the zero-sequence voltage and time; calculating a first-derivative function of the zero-sequence voltage of the previous cycle; obtaining a second first-derivative function of the zero-sequence voltage and time of the previous cycle; determining a difference function between the first first-derivative function and the second first-derivative function; and within the predetermined time zone of the maximum value point, determining the maximum value point of the absolute value of the difference function, and determining the sign of the difference function value at the maximum value point as the sign of the maximum variation increment.

Step 106: Compare the sign of the maximum variation increment with the sign of the zero-sequence current at the maximum value point, and determine a direction of an intermittent grounding fault based on a comparison result.

Optionally, determining a maximum value point of the zero-sequence current in step 102 comprises: determining a maximum value point of the zero-sequence current in a search area; in step 106, comparing the sign of the maximum variation increment with the sign of the zero-sequence current at the maximum value point and determining a direction of an intermittent grounding fault based on a comparison result comprises: if a sign of the maximum variation increment is the same as a sign of the zero-sequence current at the maximum value point, determining that the direction of the intermittent grounding fault is forward, that is, determining that the intermittent grounding fault is located in the power line; and if a sign of the maximum variation increment is opposite to a sign of the zero-sequence current at the maximum value point, determining that the direction of the intermittent grounding fault is reverse, that is, determining that the intermittent grounding fault is not located in the power line.

Specifically, determining a direction of an intermittent grounding fault based on a comparison result comprises: if a sign of the variation trend value is positive and the sign of the zero-sequence current at the maximum value point is positive, determining that the direction of the intermittent grounding fault is forward, that is, determining that the intermittent grounding fault is located in the power line; if a sign of the variation trend value is negative and the sign of the zero-sequence current at the maximum value point is negative, determining that the direction of the intermittent grounding fault is forward, that is, determining that the intermittent grounding fault is located in the power line; if a sign of the variation trend value is positive and the sign of the zero-sequence current at the maximum value point is negative, determining that the direction of the intermittent grounding fault is reverse, that is, determining that the intermittent grounding fault is not located in the power line; and if a sign of the variation trend value is negative and the sign of the zero-sequence current at the maximum value point is positive, determining that the direction of the intermittent grounding fault is reverse, that is, determining that the intermittent grounding fault is not located in the power line.

Optionally, determining a maximum value point of the zero-sequence current in step 102 comprises: determining a plurality of maximum value points of a zero-sequence current in a search area; determining the sign of the maximum variation increment of the zero-sequence voltage corresponding to the maximum value point in step 104 comprises: determining a sign of each maximum variation increment of the plurality of zero-sequence voltages corresponding to the plurality of maximum value points; in step 106, comparing the sign of the maximum variation increment with the sign of the zero-sequence current at the maximum value point and determining a direction of an intermittent grounding fault based on a comparison result comprises: if any signs of maximum variation increments are the same as the signs of zero-sequence currents at maximum value points and the number of the same signs satisfies a first preset rule, determining that the intermittent grounding fault is located in the power line; and if any signs of maximum variation increments are opposite to the signs of zero-sequence currents at maximum value points and the number of opposite signs satisfies a second preset rule, determining that the intermittent grounding fault is not located in the power line. Optionally, the first preset rule comprises: the signs of M consecutive maximum variation increments are the same as the signs of the zero-sequence currents at the corresponding maximum value point, where M is an integer greater than or equal to 2; the second preset rule comprises: the signs of N consecutive maximum variation increments are opposite to the signs of the zero-sequence currents at the corresponding maximum value point, where N is an integer greater than or equal to 2.

In an embodiment, when the absolute value of the maximum variation increment determined in step 104 is small, it may be judged that a direction of an intermittent grounding fault is undeterminable by a maximum variation increment. In this case, preferably the direction of the intermittent grounding fault is set to "undetermined".

Specifically, when the maximum absolute value of the variation trend value is smaller than a predetermined variation increment threshold, the maximum variation increment is discarded and the direction of the intermittent grounding fault is determined to be undetermined. The variation increment threshold can be set to A; A = (x%*$U_{rated}$), wherein $U_{rated}$ indicates a secondary rated voltage of the grid and x is a predetermined constant. x is preferably 3.

While a typical example of determining a maximum variation incremental threshold and a typical value of the predetermined constant x are given above, those of ordinary skill in the art will appreciate that this description is merely exemplary and is not intended to limit the scope of embodiments of the present invention.

A power grid according to an embodiment of the present invention may be an electric distribution network or a transmission network, and electric distribution networks may include high-voltage distribution networks, low-voltage distribution networks, urban distribution networks, rural distribution networks, and factory distribution networks. Transmission networks may include high-voltage transmission networks, ultrahigh-voltage transmission networks, and extra-high-voltage transmission networks.

While specific examples of power grids are given above, those of ordinary skill in the art will appreciate that the description is only exemplary and is not intended to limit the scope of embodiments of the present invention.

Based on the above analysis, specific embodiments of the present invention will be described in detail below by taking an electric distribution network as an example in combination with specific formulas and parameter definitions.

First, a zero-sequence current is generated in an electric distribution network if the following two conditions are met. The first condition is that regardless of a longitudinal fault, a lateral fault, or asymmetry that occurs when an abnormality or no abnormality happens, a zero-sequence voltage needs to be generated; the second condition is that a conductive path is established for the zero-sequence voltage.

In addition, the zero-sequence voltage ($3U_0$) and the zero-sequence current ($3I_0$) are calculated using the follow formulas:

$$3U_0 = U_A + U_B + U_C;$$

$$3I_0 = I_A + I_B + I_C;$$

wherein $I_A$ indicates an A-phase current and $U_A$ indicates an A-phase voltage; $I_B$ indicates a B-phase current and $U_B$ indicates a B-phase voltage; $I_C$ indicates a C-phase current and $U_C$ indicates a C-phase voltage.

Embodiments of the present invention are based on the assumption that an effective $3I_0$ maximum value point caused by an inrush current restrike due to an intermittent grounding fault is reliably detected. Illustratively, determining an effective $3I_0$ maximum value point comprises the following steps.

Step (a): Establish the starting criterion for the start of a fault; that is, the effective value of $3I_0$ exceeds a predetermined threshold.

Step (b): Search for the first rise starting point of $3I_0$ (which may be referred to as the zero-sequence current rise starting point). In order to find the first rise starting point of $3I_0$, from the beginning of the cycle of the time at which the starting criterion mentioned in step (a) is satisfied, determine the first rise starting point of $3I_0$ in the search area by the following formula (1), that is, determining the first $3I_0$ point that satisfies formula (1) as the first rise starting point of $3I_0$.

$$3I_0(t) > K * 3I_0(RMS) \ \&\& \ 3 \ I_0(t) > I * I_{rated} \quad \text{Formula (1)}$$

Optionally, K is set to 2.0; I is set to 5%; $3I_0(t)$ is a function of $3I_0$ with respect to time t; $3I_0(RMS)$ is the effective value of $3I_0$; && indicates a logical "AND" relationship; $I_{rated}$ indicates a rated secondary current value of the electric distribution network.

Step (c): Find the maximum value point of $3I_0$. After finding the first rise starting point of $3I_0$, from the first rise starting point of $3I_0$, search for the extreme value point of $3I_0$ within a certain period of time, for example, 3 ms, and the found extreme value point is the maximum value point of $3I_0$.

Step (d): Check whether the maximum value point of $3I_0$ is valid. If the interval between the maximum value points of two adjacent $3I_0$s is smaller than a predetermined duration, for example, 20 ms, determined on the basis of experience, then the maximum value point of the second $3I_0$ is invalid; in other words, the second pulse corresponding to the second $3I_0$ is not considered a valid pulse. The validity check performed in step (d) is intended to avoid mistakenly detecting one fault as two faults and ensures that a subsequently determined trend value works reliably.

After determining the effective $3I_0$ maximum value point, calculate the variation increment value of $\dfrac{dv}{dT}$,

wherein v indicates the zero-sequence voltage and T indicates the time. The variation increment value of $\frac{dv}{dT}$ is the variation increment determined by comparing the $\frac{dv}{dT}$ value at the maximum value point of $3I_0$ with the $\frac{dv}{dT}$ value of the cycle before the maximum value point of $3I_0$ (that is, the system cycle of the distribution network, wherein the system cycle of the distribution network is determined by the supply frequency).

The detailed process of determining the variation increment of $\frac{dv}{dT}$ is described below.

First, calculate the $\frac{dv}{dT}$ of each zero-sequence voltage collection point with the sampled value to obtain the first-derivative function $\frac{dv}{dT}(t)$ of the zero-sequence voltage, wherein:

$$\frac{dv}{dT}(t) = \frac{v(t+T_1) - v(t-T_1)}{\Delta T} \, , \quad \Delta T = 2T_1 \, ;$$

Optionally, $T_1$ is set to 0.5 ms, and so $\frac{dv}{dT}$ is a voltage change over 1 millisecond.

The influence of the $\frac{dv}{dT}$ of the previous cycle on variation increment needs to be eliminated. Thus, the difference function $\frac{dvs}{dT}(t)$ between the first-derivative function of the zero-sequence voltage and the first-derivative function of the zero-sequence voltage of the previous cycle is determined, wherein: $\frac{dvs}{dT}(t) = \frac{dv}{dT}(t) - \frac{dvs}{dT}(t-Tp)$ , wherein $Tp$ indicates a system cycle.

For example, the $\frac{dvs}{dT}$ with the largest absolute value near the $3I_0$ maximum value point within 1 millisecond to 2 milliseconds is searched. The $\frac{dvs}{dT}$ with the largest absolute value is the maximum variation increment of $\frac{dv}{dT}$ near the maximum value point of $3I_0$ (for example, within 1 millisecond to 2 milliseconds).

While specific embodiments of the present invention are described in detail by taking an electric distribution network as an example, those of ordinary skill in the art will appreciate that embodiments of the present invention can also be applied to a transmission network.

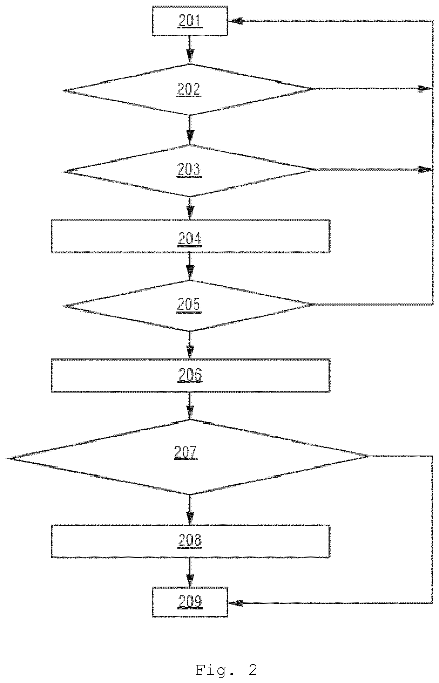

Based on the preceding analysis, Figure 2 is a flowchart of an exemplary method for determining a direction of an intermittent grounding fault in a power grid according to an embodiment of the present invention.

As shown in Figure 2, the method comprises:

Step 201: Start the process.

Step 202: Determine whether the effective value of the zero-sequence current of the distribution network is greater than or equal to a predetermined threshold; if no (that is, the effective value of the zero-sequence current is smaller than the predetermined threshold), return to step 201; if yes (that is, the effective value of the zero-sequence current is greater than or equal to the predetermined threshold), perform step 203 and subsequent steps.

Step 203: In the search area, determine whether a rise starting point of the zero-sequence current that satisfies a predetermined condition can be found; if no, return to step 201; if yes, perform step 204 and subsequent steps. The predetermined condition may be that the zero-sequence current value is greater than a product of the effective value and a first predetermined factor (for example, 2) and is greater than a product of the rated secondary current value of the distribution network and a second predetermined factor (for example, 5%).

Step 204: Retrieve the peak value of the zero-sequence current within a predetermined time interval from the rise starting point of the zero-sequence current; determine the point of the peak value as the maximum value point. For example, the predetermined time interval may be 3 milliseconds (ms).

Step 205: Determine whether the maximum value point is a valid point; if yes, perform step 206 and subsequent steps; if no, return to step 201. If the interval between two adjacent maximum value points is shorter than a predetermined duration, for example 20 ms, the second maximum value point is invalid.

Step 206: Calculate the maximum variation increment of the zero-sequence voltage at the maximum value point.

This step specifically comprises, by a sampled value of the zero-sequence voltage, calculating the $\dfrac{dv}{dT}$ of each zero-sequence voltage ($v$) for the time t to obtain the first-derivative function $\dfrac{dv}{dT}(t)$ of the zero-sequence voltage.

$$\frac{dv}{dT}(t) = \frac{v(t+T_1) - v(t-T_1)}{\Delta T}$$

, wherein $\Delta T = 2T_1$; optionally, $T_1$ is set to 0.5 ms. The $\dfrac{dv}{dT}$ of the previous cycle needs to be eliminated. Therefore, calculate $\dfrac{dvs}{dT}(t) = \dfrac{dv}{dT}(t) - \dfrac{dvs}{dT}(t - Tp)$ , wherein $Tp$ indicates a system cycle.

Search for the $\dfrac{dvs}{dT}$ with the largest absolute value near the maximum value point of the zero-sequence current within 1 millisecond to 2 milliseconds. The $\dfrac{dvs}{dT}$ with the largest absolute value is the maximum variation increment of $\dfrac{dv}{dT}$ near the maximum value point (within 1 millisecond to 2 milliseconds).

Step 207: Determine whether the maximum variation increment is greater than a predetermined variation increment threshold; if yes, perform step 208 and subsequent steps; if no, return to step 201. The variation increment threshold is A; A = ($x\%*U_{rated}$), wherein $U_{rated}$ indicates a secondary rated voltage of the distribution network; x is a predetermined constant, preferably 3.

Step 208: Compare the sign of the maximum variation increment with the sign of the zero-sequence current at the maximum value point, and determine a direction of an intermittent grounding fault based on a comparison result.

When one maximum value point of the zero-sequence current is determined in step 204:

(1) If the sign of the maximum variation increment is positive and the sign of the zero-sequence current at the maximum value point is positive, it is determined that the direction of the intermittent grounding fault is forward, that is, the intermittent grounding fault is located in the power line;

(2) If the sign of the maximum variation increment is negative and the sign of the zero-sequence current at the maximum value point is negative, it is determined that the direction of the intermittent grounding fault is forward, that is, the intermittent grounding fault is located in the power line;

(3) If the sign of the maximum variation increment is positive and the sign of the zero-sequence current at the maximum value point is negative, it is determined that the direction of the intermittent grounding fault is reverse, that is, the intermittent grounding fault is not located in the power line;

(4) If the sign of the maximum variation increment is negative and the sign of the zero-sequence current at the maximum value point is positive, it is determined that the direction of the intermittent grounding fault is reverse, that is, the intermittent grounding fault is not located in the power line.

When more than one maximum value point of the zero-sequence current are determined in step 204:

(1) If any signs of maximum variation increments are the same as the signs of zero-sequence currents at maximum value points and the number of the same signs satisfies a first preset rule, it is determined that the direction of the intermittent grounding fault is forward, that is, the intermittent grounding fault is located in the power line. For example, the first preset rule comprises: the signs of M consecutive maximum variation increments are the same as the signs of the zero-sequence currents at the corresponding maximum value point, where M is an integer greater than or equal to 2.

(2) If any signs of maximum variation increments are opposite to the signs of zero-sequence currents at the maximum value points and the number of opposite signs satisfies a second preset rule, it is determined that the direction of the intermittent grounding fault is reverse, that is, it is determined that the intermittent grounding fault is not located in the power line. For example, the second preset rule comprises: the signs of N consecutive maximum variation increments are opposite to the signs of the zero-sequence currents at the corresponding maximum value point, where N is an integer greater than or equal to 2.

Step 209: End the process.

Typical applications of embodiments of the present invention are described below.

In the prior art, a direction of an intermittent grounding fault is determined on the basis of included angles between zero-sequence currents and zero-sequence voltages. In contrast, an embodiment of the present invention determines a direction of an intermittent grounding fault by comparing the signs of the maximum variation increments

of $\dfrac{dv}{dT}$ near maximum value points of zero-sequence currents and the signs of the maximum zero-sequence current values, allowing more accurate and more reliable determination. In particular, the advantages of embodiments of the present invention are apparent in determining faults that have significant sinusoidal zero-sequence voltages before current restrikes of intermittent grounding faults.

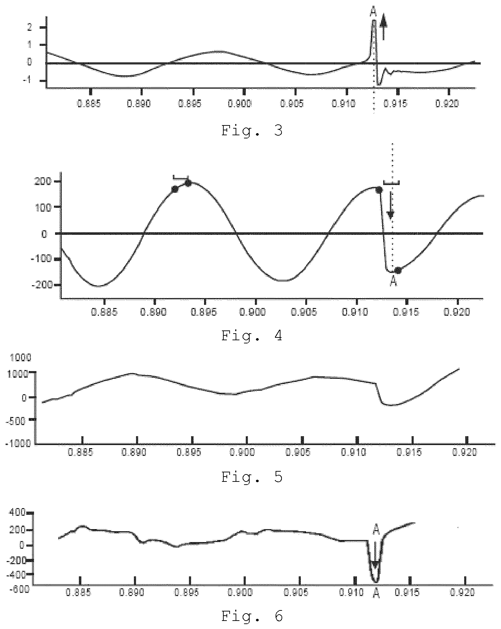

Figure 3 is a schematic diagram for a zero-sequence current pulse generated when a single-phase fault had existed before a current restrike according to an embodiment of the present invention, wherein an inrush current is generated after the current restrike. Figure 4 is a schematic diagram for the zero-sequence voltage pulse shown in Figure 3; Figure 5 is a schematic diagram for a first-derivative function of the zero-sequence voltage shown in Figure 3; Figure 6 is a schematic diagram for a difference function between a first-derivative function of the zero-sequence voltage shown in Figure 3 and a first-derivative function of a zero-sequence voltage of the previous cycle. In Figure 3, the abscissa axis is the time axis, and the ordinate axis indicates the current value; in Figure 4, the abscissa axis is the time axis, and the ordinate axis indicates the voltage value; in Figure 5, the abscissa axis is the time axis, and the ordinate axis indicates the ratio of voltage to time; in Figure 6, the abscissa axis is the time axis, and the ordinate axis indicates the ratio of voltage to time.

In the examples shown in Figures 3 to 6, a single-phase fault occurred before the current restrike, and so a significant zero-sequence voltage was generated before the rise of the intermittent grounding fault current. With the prior art, which is based on phase angles between zero-sequence currents and zero-sequence voltages, direction results are undeterminable. During a pulse, a sampled value of a zero-sequence current is positive and that of a zero-sequence voltage is partially positive and partially negative; consequently, the fault direction is undeterminable.

After an embodiment of the present invention is implemented, as shown in Figure 3, the zero-sequence current at the maximum value point A is greater than zero and so its sign is positive. Further, as shown in Figure 4, the sign of the maximum variation increment of $\dfrac{dv}{dT}$ near the maximum value point A is clearly negative. Therefore, the sign of the zero-sequence current at the maximum value point A is different from the sign of the maximum variation increment of

$\dfrac{dv}{dT}$ near the maximum value point A, and so the direction of the intermittent grounding fault is reverse. Figure 6 clearly shows that the sign of the maximum variation increment of $\dfrac{dv}{dT}$ near the maximum value point A is negative.

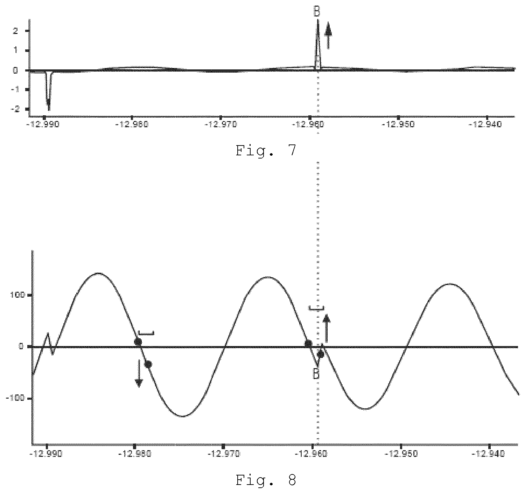

Figure 7 is a schematic diagram for a zero-sequence current pulse generated when current restrike occurs during a single-phase fault according to an embodiment of the present invention; Figure 8 is a schematic diagram for a zero-sequence voltage pulse generated when current restrike occurs during a single-phase fault according to an embodiment of the present invention. In Figure 7, the abscissa axis is the time axis, and the ordinate axis indicates the current value; in Figure 8, the abscissa axis is the time axis, and the ordinate axis indicates the voltage value.

In the examples shown in Figures 7 to 8, current restrike occurs during a static grounding fault. As shown in Figure 7, the zero-sequence current value at the maximum value point B of the zero-sequence current is greater than zero, and so the sign is positive. As shown in Figure 8, the sign of the $\dfrac{dv}{dT}$ value near the maximum value point B of the zero-sequence current is positive, and the sign of its value in the previous cycle of the maximum value point B is negative. Therefore, the sign of the maximum variation increment of $\dfrac{dv}{dT}$ near the maximum value point B is positive. It is thus clear that the sign of the zero-sequence current at the maximum value point B is the same as the sign of the maximum variation increment of $\dfrac{dv}{dT}$ at the maximum value point B, and so the direction of the intermittent grounding fault is positive.

Based on the preceding description, an embodiment of the present invention further proposes an apparatus for determining a direction of an intermittent grounding fault in an electric distribution network.

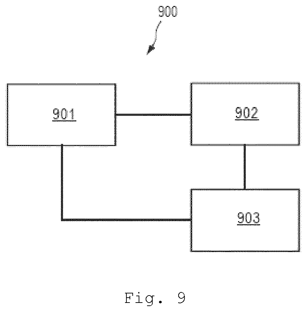

Figure 9 is a structural diagram for an apparatus for determining a direction of an intermittent grounding fault in an electric distribution network according to an embodiment of the present invention.

As shown in Figure 9, the apparatus 900 comprises:

a maximum value point determination module 901, configured to, if an effective value of a zero-sequence current of a power line of a power grid is greater than or equal to a predetermined threshold, determine a maximum value point of the zero-sequence current;
a sign determination module 902, configured to determine the sign of the maximum variation increment of the zero-sequence voltage corresponding to the maximum value point; and
a comparison module 903, configured to compare the sign of the maximum variation increment with the sign of the zero-sequence current at the maximum value point and, based on a comparison result, determine whether the intermittent grounding fault is located in the power line.

In an embodiment, the comparison module 903 is specifically configured to, if the sign of the maximum variation increment is the same as the sign of the zero-sequence current at the maximum value point, determine that the intermittent grounding fault is located in the power line, and if a sign of the maximum variation increment is opposite to a sign of the zero-sequence current at the maximum value point, determine that the intermittent grounding fault is not located in the power line.

In an embodiment, the maximum value point determination module 901 is specifically configured to determine a plurality of maximum value points of a zero-sequence current in a search area; the comparison module 903 is specifically configured to, if the signs of maximum variation increments are the same as the signs of zero-sequence currents at maximum value points and the number of the same signs satisfies a first preset rule, determine that the intermittent grounding fault is located in the power line, and if the signs of maximum variation increments are opposite to the signs of zero-sequence currents at maximum value points and the number of opposite signs satisfies a second preset rule, determine that the intermittent grounding fault is not located in the power line.

In an embodiment, the first preset rule comprises: the signs of M consecutive maximum variation increments are the same as the signs of zero-sequence currents at a corresponding maximum value point, wherein M is an integer greater than or equal to 2; the second preset rule comprises: the signs of N consecutive maximum variation increments are opposite to the signs of the zero-sequence currents at the corresponding maximum value point, where N is an integer greater than or equal to 2.

In an embodiment, the maximum value point determination module 901 is further configured to, before the comparison module 903 compares the sign of the maximum variation increment with the sign of the zero-sequence current at the maximum value point, determine a time interval difference between two adjacent maximum value points, and, if the time interval difference is smaller than a predetermined interval difference threshold, discard the latter of the two adjacent maximum value points.

In an embodiment, the maximum value point determination module 901 is configured to, from the starting point of a cycle of the time at which the effective value of the zero-sequence current of the power line is greater than the predetermined threshold, determine the rise starting point of the zero-sequence current; determine the peak value of the zero-sequence current from the rise starting point of the zero-sequence current; and determine a current point corresponding to the peak value as the maximum value point.

In an embodiment, the maximum value point determination module 901 is configured to determine whether the zero-sequence current of the power line satisfies a first predetermined condition, and if the determination result is yes, determine that the zero-sequence current of the power line is a rise starting point; the first predetermined condition comprises: a sampled value of the zero-sequence current is greater than a product of the effective value and a first predetermined factor, and a current value of the zero-sequence current is greater than a product of a rated secondary current value of the power grid and a second predetermined factor, the first predetermined factor being greater than 1, the second predetermined factor being smaller than 1.

In an embodiment, the sign determination module 902 is configured to obtain a first first-derivative function of the zero-sequence voltage and time; obtain a second first-derivative function of the zero-sequence voltage and time of the previous cycle; determine a difference function between the first first-derivative function and the second first-derivative function; and within a predetermined time area of the maximum value point, determine a maximum value point of the absolute value of the difference function, and determine the sign of the difference function value at the maximum value point as the sign of the maximum variation increment.

In an embodiment, the comparison module 903 is further configured to, after the sign determination module 902 determines the sign of the maximum variation increment and before comparing the sign of the maximum variation increment with the sign of the zero-sequence current at the maximum value point, determine whether the absolute value of the maximum variation increment is greater than or equal to a predetermined variation increment threshold, and if no, discard the maximum variation increment and determine that a direction of the intermittent grounding fault is undetermined.

In an embodiment, the comparison module 903 is further configured to, after determination of the sign of the maximum variation increment and before comparison of the sign of the maximum variation increment with the sign of the zero-sequence current at the maximum value point, determine whether the absolute value of the maximum variation increment is greater than or equal to a predetermined variation increment threshold, and if yes, compare the sign of the maximum variation increment with the sign of the zero-sequence current at the maximum value point.

In an embodiment, the variation increment threshold is A; $A = x\% * U_{rated}$, wherein $U_{rated}$ indicates a secondary rated voltage of the grid and x is a predetermined constant.

The methods for operating the respective modules of the above-mentioned apparatus and the corresponding beneficial effects are the same as those of the embodiments described above, and are not described herein again.

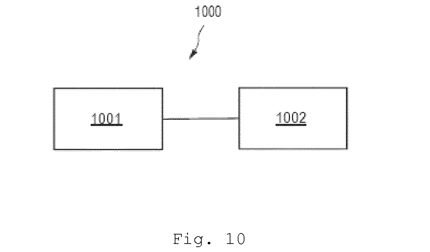

Figure 10 is a structural diagram for an apparatus for determining a direction of an intermittent grounding fault in an electric distribution network according to an embodiment of the present invention.

As shown in Figure 10, the apparatus 100 for determining a direction of an intermittent grounding fault in a power grid comprises a processor 1001 and a memory 1002;

The memory 1001 stores an application executable by the processor 1002 for causing the processor 1002 to perform the steps of the method for determining a direction of an intermittent grounding fault in a power grid as described in any one of the embodiments above.

It should be noted that not all the steps and modules in the above-mentioned processes or the various structural diagrams are required, and some of the steps or modules may be omitted as needed. The sequence of performing the steps is not fixed and can be adjusted as needed. The division of modules is only intended to facilitate the description of the adopted functional division. In actual implementation, the functions of a module may be implemented separately by a plurality of modules, and the functions of a plurality of modules may also be implemented by the same module. These modules can be located in the same device or in different devices.

Hardware modules adopted in various embodiments may be implemented mechanically or electronically. For example, a hardware module can comprise specially designed permanent circuits or logic devices, such as dedicated processors and FPGAs or ASICs, for performing specific operations. A hardware module may also comprise programmable logic devices or circuits, for example, general-purpose processors or other programmable processors, that are temporarily configured by software for performing specific operations. Whether a hardware module is to be implemented mechanically, by using a dedicated permanent circuit, or by using a temporarily configured circuit, for example, one configured by software, can be determined considering costs and time consumption.

The present invention further provides a machine-readable storage medium storing instructions for causing a machine to perform a method as described herein. Specifically, a system or apparatus equipped with a storage medium can be provided, the storage medium storing software program code for implementing the functions of any one of the above-described embodiments, and a computer (or a CPU or a MPU) of the system or apparatus may be caused to read and execute the program code stored in the storage medium. Further, some or all of the actual operations may be performed by an operating system etc. running on a computer based on instructions of the program code. In addition, program code read out from the storage medium can be written into a memory installed in an expansion board inserted in the computer or into a memory installed in an extension unit connected to the computer. Then, based on the instructions of the program code, the CPU etc. installed on the expansion board or the expansion unit are caused to perform part and all of the actual operations, thereby implementing the functions of any one of the above embodiments.

Examples of storage media for providing program code include floppy disks, hard disks, magneto-optical disks, optical disks (such as CD-ROMs, CD-Rs, CD-RWs, DVD-ROMs, DVD-RAMs, DVD-RWs, and DVD+RWs), magnetic tapes, non-volatile memory cards, and ROMs. Optionally, program code can be downloaded from a server computer via a communications network.

While the present invention has been particularly described above with reference to preferred embodiments, it should be understood that said embodiments are not intended to limit the present invention and that modifications, equivalent substitutions, and improvements can be made without departing from the scope of the present invention as defined by the claims.

**Claims**

1. A method for determining a direction of an intermittent grounding fault in a power grid, the method comprising:

   - if an effective value of a zero-sequence current of a power line of the power grid is greater than or equal to a predetermined threshold, determining a maximum value point of the zero-sequence current in a first step (102, 204),

   the method **characterised by** the steps of:

   - determining a sign of a maximum variation increment of the zero-sequence voltage corresponding to the maximum value point in a second step (104, 206); and
   - comparing the sign of the maximum variation increment with the sign of the zero-sequence current at the maximum value point in a third step (106, 208) and, based on the comparison result, determining whether the intermittent grounding fault is located in the power line,
   - wherein the direction of the intermittent grounding fault is determined to be forward, if the intermittent grounding fault is located in the power line, and is else determined to be reverse if the intermittent grounding fault is not located in the power line.

2. The method for determining a direction of an intermittent grounding fault in a power grid as claimed in claim 1, **characterized in that**

   - said comparing the sign of the maximum variation increment with the sign of the zero-sequence current at the maximum value point in the third step (106, 208) and, based on the comparison result, determining whether the intermittent grounding fault is located in the power line comprises: if the sign of the maximum variation increment is the same as the sign of the zero-sequence current at the maximum value point, determining that the intermittent grounding fault is located in the power line; and if the sign of the maximum variation increment is opposite to the sign of the zero-sequence current at the maximum value point, determining that the intermittent grounding fault is not located in the power line.

3. The method for determining a direction of an intermittent grounding fault in a power grid as claimed in claim 1 or 2, **characterized in that**

   - said determining the maximum value point of the zero-sequence current in the first step (102, 204) comprises: determining a plurality of maximum value points of the zero-sequence current in a search area;
   - said determining the sign of the maximum variation increment of the zero-sequence voltage corresponding to the maximum value point in the second step (104, 206) comprises: determining the signs of each maximum variation increment of the plurality of zero-sequence voltages corresponding to the plurality of maximum value points;
   - said comparing the sign of the maximum variation increment with the sign of the zero-sequence current at the maximum value point in the third step (106, 208) and, based on the comparison result, determining whether the intermittent grounding fault is located in the power line comprises: if any signs of maximum variation increments are the same as the signs of the zero-sequence currents at the maximum value points and the number of the same signs satisfies a first preset rule, determining that the intermittent grounding fault is located in the power line; and if any signs of the maximum variation increments are opposite to the signs of the zero-sequence currents at the maximum value points and the number of opposite signs satisfies a second preset rule, determining that the intermittent grounding fault is not located in the power line;

- preferably, the first preset rule comprises: the signs of M consecutive maximum variation increments are the same as the signs of the zero-sequence currents at corresponding maximum value points, wherein M is an integer greater than or equal to 2;

- preferably, the second preset rule comprises: the signs of N consecutive maximum variation increments are opposite to the signs of the zero-sequence currents at a corresponding maximum value point, wherein N is an integer greater than or equal to 2.

4. The method for determining a direction of an intermittent grounding fault in a power grid as claimed in any one of claims 1 to 3, **characterized in that**

- before comparing the sign of the maximum variation increment with the sign of the zero-sequence current at the maximum value point in the third step (106, 208), the method further comprises in the first step (102, 204):

- determining a time interval difference between two adjacent maximum value points and, when the time interval difference is smaller than a predetermined interval difference threshold, discarding the latter of the two adjacent maximum value points in a first intermediate step (205).

5. The method for determining a direction of an intermittent grounding fault in a power grid as claimed in any one of claims 1 to 4, **characterized in that**: said determining the maximum value point of the zero-sequence current in the first step (102, 204) comprises:

- from the starting point of a cycle of the time at which the effective value of the zero-sequence current of the power line is greater than the predetermined threshold, determining the rise starting point of the zero-sequence current in a second intermediate step (203);

- determining the peak value of the zero-sequence current from the rise starting point of the zero-sequence current in the second intermediate step (203);

- determining a current point corresponding to the peak value as the maximum value point in the first step (102, 204);

- preferably, said determining the rise starting point of the zero-sequence current in the second intermediate step (203) comprises: determining whether the zero-sequence current of the power line satisfies a first predetermined condition, and if yes, determining that the zero-sequence current of the power line is the rise starting point;

- preferably, the first predetermined condition comprises: a sampled value of the zero-sequence current is greater than the product of the effective value and a first predetermined factor, and the current value of the zero-sequence current is greater than the product of a rated secondary current value of the power grid and a second predetermined factor, the first predetermined factor being greater than 1 and the second predetermined factor being smaller than 1;

- more preferably, the first predetermined factor is 2 and the second predetermined factor is 5%.

6. The method for determining a direction of an intermittent grounding fault in a power grid as claimed in any one of claims 1 to 5, **characterized in that**: said determining the sign of the maximum variation increment of the zero-sequence voltage corresponding to the maximum value point in the second step (104, 206) comprises:

- obtaining a first first-derivative function of the zero-sequence voltage and time;

- obtaining a second first-derivative function of the zero-sequence voltage and time of the previous cycle;

- determining a difference function between the first first-derivative function and the second first-derivative function; and

- within a predetermined time area of the maximum value point, determining a maximum value point of the absolute value of the difference function, and determining the sign of the difference function value at the maximum value point as the sign of the maximum variation increment.

7. The method for determining a direction of an intermittent grounding fault in a power grid as claimed in any one of claims 1 to 6, **characterized in that**: after determination of the sign of the maximum variation increment in step (104, 206), and before comparing the sign of the maximum variation increment with the sign of the zero-sequence current at the maximum value point in the third step (106, 208), the method further comprises:

- determining whether the absolute value of the maximum variation increment is greater than or equal to a predetermined variation increment threshold, and if no, discarding the maximum variation increment and determining that a direction of the intermittent grounding fault is undetermined, or
- determining whether the absolute value of the maximum variation increment is greater than or equal to a predetermined variation increment threshold in a third intermediate step (207), and if yes, comparing the sign of the maximum variation increment with the sign of the zero-sequence current at the maximum value point in the third step (106, 208); preferably, the variation increment threshold is A;

$$A = x\%*U_{rated};$$

wherein $U_{rated}$ indicates the secondary rated voltage value of the power grid; x is a predetermined constant;

wherein x is preferably 3.

8. An apparatus (900) for determining a direction of an intermittent grounding fault in a power grid, the apparatus comprising:

- a maximum value point determination module (901), configured to, if an effective value of a zero-sequence current of a power line of a power grid is greater than or equal to a predetermined threshold, determine a maximum value point of the zero-sequence current, the apparatus **characterised by**:

- a sign determination module (902), configured to determine the sign of the maximum variation increment of the zero-sequence voltage corresponding to the maximum value point; and
- a comparison module (903), configured to compare the sign of the maximum variation increment with the sign of the zero-sequence current at the maximum value point and, based on the comparison result, determine whether the intermittent grounding fault is located in the power line;

wherein the comparison module is configured to determine the direction of the intermittent grounding fault to be forward, if the intermittent grounding fault is located in the power line, and else to determine the direction to be reverse if the intermittent grounding fault is not located in the power line.

9. The apparatus (900) for determining a direction of an intermittent grounding fault in a power grid as claimed in claim 8, **characterized in that**

- the comparison module (903) is specifically configured to, if the sign of the maximum variation increment is the same as the sign of the zero-sequence current at the maximum value point, determine that the intermittent grounding fault is located in the power line, and if the sign of the maximum variation increment is opposite to the sign of the zero-sequence current at the maximum value point, determine that the intermittent grounding fault is not located in the power line.

10. The apparatus (900) for determining a direction of an intermittent grounding fault in a power grid as claimed in claim 8 or claim 9, **characterized in that**

- the maximum value point determination module (901) is specifically configured to determine a plurality of maximum value points of the zero-sequence current in a search area;
- the comparison module (903) is specifically configured to, if any signs of the maximum variation increments are the same as the signs of the zero-sequence currents at the maximum value points and the number of the same signs satisfies a first preset rule, determine that the intermittent grounding fault is located in the power line, and if any signs of the maximum variation increments are opposite to the signs of the zero-sequence currents at the maximum value points and the number of opposite signs satisfies a second preset rule, determine that the intermittent grounding fault is not located in the power line;
- preferably, the first preset rule comprises: the signs of M consecutive maximum variation increments are the same as the signs of the zero-sequence currents at the corresponding maximum value points, wherein M is an integer greater than or equal to 2;
- preferably, the second preset rule comprises: the signs of N consecutive maximum variation increments are opposite to the signs of the zero-sequence currents at the corresponding maximum value points, wherein N is an integer greater than or equal to 2.

**11.** The apparatus (900) for determining a direction of an intermittent grounding fault in a power grid as claimed in any one of claims 8 to 10, **characterized in that**

- the maximum value point determination module (901) is further configured to, before the comparison module (903) compares the sign of the maximum variation increment with the sign of the zero-sequence current at the maximum value point, determine a time interval difference between two adjacent maximum value points, and, if the time interval difference is smaller than a predetermined interval difference threshold, discard the latter of the two adjacent maximum value points.

**12.** The apparatus (900) for determining a direction of an intermittent grounding fault in a power grid as claimed in any one of claims 8 to 11, **characterized in that**

- the maximum value point determination module (901) is configured to, from the starting point of a cycle of the time at which the effective value of the zero-sequence current of the power line is greater than the predetermined threshold, determine the rise starting point of the zero-sequence current; determine the peak value of the zero-sequence current from the rise starting point of the zero-sequence current; and determine a current point corresponding to the peak value as the maximum value point;
- preferably, the maximum value point determination module (901) is configured to determine whether the zero-sequence current of the power line satisfies a first predetermined condition, and if yes, determine that the zero-sequence current of the power line is a rise starting point;
- preferably, the first predetermined condition comprises: a sampled value of the zero-sequence current is greater than the product of the effective value and a first predetermined factor, and the current value of the zero-sequence current is greater than the product of a rated secondary current value of the power grid and a second predetermined factor, the first predetermined factor being greater than 1, and the second predetermined factor being smaller than 1;
- more preferably, the first predetermined factor is 2 and the second predetermined factor is 5.

**13.** The apparatus (900) for determining a direction of an intermittent grounding fault in a power grid as claimed in any one of claims 8 to 12, **characterized in that**

- the sign determination module (902) is configured to obtain a first first-derivative function of the zero-sequence voltage and time; obtain a second first-derivative function of the zero-sequence voltage and time of the previous cycle; determine a difference function between the first first-derivative function and the second first-derivative function; and within a predetermined time area of the maximum value point, determine the maximum value point of the absolute value of the difference function, and determine the sign of the difference function value at the maximum value point as the sign of the maximum variation increment.

**14.** The apparatus (900) for determining a direction of an intermittent grounding fault in a power grid as claimed in any one of claims 8 to 12, **characterized in that**

- the comparison module (903) is further configured to, after the sign determination module (902) determines the sign of the maximum variation increment and before comparing the sign of the maximum variation increment with the sign of the zero-sequence current at the maximum value point, determine whether the absolute value of the maximum variation increment is greater than or equal to a predetermined variation increment threshold, and if no, discard the maximum variation increment and determine that the direction of the intermittent grounding fault is undetermined; or
- the comparison module (903) is further configured to, after the sign of the maximum variation increment is determined and before comparing the sign of the maximum variation increment with the sign of the zero-sequence current at the maximum value point, determine whether the absolute value of the maximum variation increment is greater than or equal to a predetermined variation increment threshold, and if yes, compare the sign of the maximum variation increment with the sign of the zero-sequence current at the maximum value point;

preferably, the variation increment threshold is A;

$$A = x\% * U_{rated};$$

wherein $U_{rated}$ indicates the secondary rated voltage value of the power grid; x is a predetermined constant, and x is preferably 3.

15. An apparatus (1000) for determining a direction of an intermittent grounding fault in a power grid, **characterized in that** the apparatus comprises: a processor (1001) and a memory (1002);
the memory (1002) storing an application executable by the processor (1001) for causing the processor (1001) to perform the steps of the method for determining a direction of an intermittent grounding fault in a power grid as claimed in any one of claims 1 to 7.

16. A computer-readable storage medium, **characterized in that** it stores computer-readable instructions for performing the steps of the method for determining a direction of an intermittent grounding fault in a power grid as claimed in any one of claims 1 to 7.

**Patentansprüche**

1. Verfahren zum Bestimmen einer Richtung eines intermittierenden Erdungsfehlers in einem Stromnetz, wobei das Verfahren umfasst

- falls ein Effektivwert eines Nullsequenzstroms einer Stromleitung des Stromnetzes größer oder gleich einem vorbestimmten Schwellwert ist, Bestimmen eines Maximalwertpunkts des Nullsequenzstroms in einem ersten Schritt (102, 204),

wobei das Verfahren durch die folgenden Schritte gekennzeichnet ist:

- Bestimmen eines Vorzeichens eines Maximalvariationsinkrements der Nullsequenzspannung entsprechend dem Maximalwertpunkt in einem zweiten Schritt (104, 206); und
- Vergleichen des Vorzeichens des Maximalvariationsinkrements mit dem Vorzeichen des Nullsequenzstroms bei dem Maximalwertpunkt in einem dritten Schritt (106, 208) und, auf Basis des Vergleichsergebnisses, Bestimmen, ob sich der intermittierende Erdungsfehler in der Stromleitung befindet,
- wobei die Richtung des intermittierenden Erdungsfehlers als Vorwärts bestimmt wird, falls sich der intermittierende Erdungsfehler in der Stromleitung befindet, und ansonsten als Rückwärts bestimmt wird, falls sich der intermittierende Erdungsfehler nicht in der Stromleitung befindet.

2. Verfahren zum Bestimmen einer Richtung eines intermittierenden Erdungsfehlers in einem Stromnetz nach Anspruch 1, **dadurch gekennzeichnet, dass**

- das Vergleichen des Vorzeichens des Maximalvariationsinkrements mit dem Vorzeichen des Nullsequenzstroms bei dem Maximalwertpunkt in dem dritten Schritt (106, 208) und auf Basis des Vergleichsergebnisses das Bestimmen, ob sich der intermittierende Erdungsfehler in der Stromleitung befindet, umfasst: falls das Vorzeichen des Maximalvariationsinkrements das gleiche ist wie das Vorzeichen des Nullsequenzstroms bei dem Maximalwertpunkt, Bestimmen, dass sich der intermittierende Erdungsfehler in der Stromleitung befindet; und falls das Vorzeichen des Maximalvariationsinkrements dem Vorzeichen des Nullsequenzstroms an dem Maximalwertpunkt entgegengesetzt ist, Bestimmen, dass sich der intermittierende Erdungsfehler nicht in der Stromleitung befindet.

3. Verfahren zum Bestimmen einer Richtung eines intermittierenden Erdungsfehlers in einem Stromnetz nach Anspruch 1 oder 2, **dadurch gekennzeichnet, dass**

- das Bestimmen des Maximalwertpunkts des Nullsequenzstroms in dem ersten Schritt (102, 204) umfasst: Bestimmen von mehreren Maximalwertpunkten des Nullsequenzstroms in einem Suchbereich;
- das Bestimmen des Vorzeichens des Maximalvariationsinkrements der Nullsequenzspannung entsprechend dem Maximalwertpunkt in dem zweiten Schritt (104, 206) umfasst: Bestimmen der Vorzeichen jedes Maximalvariationsinkrements der mehreren Nullsequenzspannungen entsprechend den mehreren Maximalwertpunkten;
- das Vergleichen des Vorzeichens des Maximalvariationsinkrements mit dem Vorzeichen des Nullsequenzstroms an dem Maximalwertpunkt in dem dritten Schritt (106, 208) und, auf Basis des Vergleichsergebnisses, Bestimmen, ob sich der intermittierende Erdungsfehler in der Stromleitung befindet, umfasst: falls etwaige Vorzeichen von Maximalvariationsinkrementen die gleichen sind wie die Vorzeichen der Nullsequenzströme an den Maximalwertpunkten und die Anzahl der gleichen Vorzeichen einer ersten voreingestellten Regel genügt, Bestimmen, dass sich der intermittierende Erdungsfehler in der Stromleitung befindet; und falls etwaige Vorzeichen der Maximalvariationsinkremente den Vorzeichen der Nullsequenzströme an den Maximalwertpunkten entgegengesetzt sind und die Anzahl von entgegengesetzten Vorzeichen einer zweiten voreingestellten Regel genügt, Bestimmen, dass sich der intermittierende Erdungsfehler nicht in der Stromleitung befindet;
- bevorzugt umfasst die erste voreingestellte Regel: die Vorzeichen von M aufeinander folgenden Maximalvariationsinkrementen sind die gleichen wie die Vorzeichen der Nullsequenzströme an entsprechenden Maximalwertpunkten, wobei M eine ganze Zahl größer oder gleich 2 ist;
- bevorzugt umfasst die zweite voreingestellte Regel: die Vorzeichen von N aufeinanderfolgenden Maximalvariationsinkrementen sind den Vorzeichen der Nullsequenzströme an einem entsprechenden Maximalwertpunkt entgegengesetzt, wobei N eine ganze Zahl größer oder gleich 2 ist.

4. Verfahren zum Bestimmen einer Richtung eines intermittierenden Erdungsfehlers in einem Stromnetz nach einem der Ansprüche 1 bis 3, **dadurch gekennzeichnet, dass**

   - vor dem Vergleichen des Vorzeichens des Maximalvariationsinkrements mit dem Vorzeichen des Nullsequenzstroms bei dem Maximalwertpunkt in dem dritten Schritt (106, 208), das Verfahren weiter in dem ersten Schritt (102, 204) umfasst:

   - Bestimmen einer Zeitintervalldifferenz zwischen zwei benachbarten Maximalwertpunkten und, wenn die Zeitintervalldifferenz kleiner ist als ein vorbestimmter Intervalldifferenzschwellwert, Verwerfen des letzteren der beiden benachbarten Maximalwertpunkte in einem ersten Zwischenschritt (205).

5. Verfahren zum Bestimmen einer Richtung eines intermittierenden Erdungsfehlers in einem Stromnetz nach einem der Ansprüche 1 bis 4, **dadurch gekennzeichnet, dass**: das Bestimmen des Maximalwertpunkts des Nullsequenzstroms in dem ersten Schritt (102, 204) umfasst:

   - ab dem Anfangspunkt eines Zyklus der Zeit, bei der der Effektivwert des Nullsequenzstroms der Stromleitung größer ist als der vorbestimmte Schwellwert, Bestimmen des Anstiegsanfangspunkts des Nullsequenzstroms in einem zweiten Zwischenschritt (203);
   - Bestimmen des Spitzenwerts des Nullsequenzstroms aus dem Anstiegsanfangspunkt des Nullsequenzstroms in dem zweiten Zwischenschritt (203);
   - Bestimmen eines aktuellen Punkts entsprechend dem Spitzenwert als den Maximalwertpunkt in dem ersten Schritt (102, 204);
   - bevorzugt umfasst das Bestimmen des Anstiegsanfangspunkts des Nullsequenzstroms in dem zweiten Zwischenschritt (203): Bestimmen, ob der Nullsequenzstrom der Stromleitung einem ersten vorbestimmten Zustand entspricht, und falls ja, Bestimmen, dass der Nullsequenzstrom der Stromleitung der Anstiegsanfangspunkt ist;
   - bevorzugt umfasst der erste vorbestimmte Zustand: ein abgetasteter Wert des Nullsequenzstroms ist größer als das Produkt aus dem Effektivwert und einem ersten vorbestimmten Faktor, und der aktuelle Wert des Nullsequenzstroms ist größer als das Produkt aus einem sekundären aktuellen Nennwert des Stromnetzes und einem zweiten vorbestimmten Faktor, wobei der erste vorbestimmte Faktor größer als 1 ist und der zweite vorbestimmte Faktor kleiner als 1 ist;
   - besonders bevorzugt beträgt der erste vorbestimmte Faktor 2 und der zweite vorbestimmte Faktor 5%.

6. Verfahren zum Bestimmen einer Richtung eines intermittierenden Erdungsfehlers in einem Stromnetz nach einem der Ansprüche 1 bis 5, **dadurch gekennzeichnet, dass**: das Bestimmen des Vorzeichens des Maximalvariationsinkrements der Nullsequenzspannung entsprechend dem Maximalwertpunkt in dem zweiten Schritt (104, 206) umfasst:

   - Erhalten einer ersten Erste-Ableitungsfunktion der Nullsequenzspannung und Zeit;
   - Erhalten einer zweiten Erste-Ableitungsfunktion der Nullsequenzspannung und Zeit des vorausgegangenen Zyklus;
   - Bestimmen einer Differenzfunktion zwischen der ersten Erste-Ableitungsfunktion und der zweiten Erste-Ableitungsfunktion; und
   - innerhalb eines vorbestimmten Zeitbereichs des Maximalwertpunkts, Bestimmen eines Maximalwertpunkts des Betrags der Differenzfunktion und Bestimmen des Vorzeichens des Differenzfunktionswerts bei dem Maximalwertpunkt als das Vorzeichen des Maximalvariationsinkrements.

**7.** Verfahren zum Bestimmen einer Richtung eines intermittierenden Erdungsfehlers in einem Stromnetz nach einem der Ansprüche 1 bis 6, **dadurch gekennzeichnet, dass**: nach der Bestimmung des Vorzeichens des Maximalvariationsinkrements in Schritt (104, 206) und vor dem Vergleichen des Vorzeichens des Maximalvariationsinkrements mit dem Vorzeichen des Nullsequenzstroms bei dem Maximalwertpunkt in dem dritten Schritt (106, 208) das Verfahren weiter umfasst:

- Bestimmen, ob der Betrag des Maximalvariationsinkrements größer oder gleich einem vorbestimmten Variationsinkrementschwellwert ist, und falls nein, Verwerfen des Maximalvariationsinkrements und Bestimmen, dass eine Richtung des intermittierenden Erdungsfehlers unbestimmt ist, oder
- Bestimmen, ob der Betrag des Maximalvariationsinkrements größer oder gleich einem vorbestimmten Variationsinkrementschwellwert in einem dritten Zwischenschritt (207) ist, und falls ja, Vergleichen des Vorzeichens des Maximalvariationsinkrements mit dem Vorzeichen des Nullsequenzstroms bei dem Maximalwertpunkt in dem dritten Schritt (106, 208); bevorzugt beträgt der Variationsinkrementschwellwert A;

$$A = x\% * U_{nenn};$$

wobei $U_{nenn}$ den sekundären Nennspannungswert des Stromnetzes angibt; x eine vorbestimmte Konstante ist; wobei x bevorzugt 3 beträgt.

**8.** Vorrichtung (900) zum Bestimmen einer Richtung eines intermittierenden Erdungsfehlers in einem Stromnetz, wobei die Vorrichtung umfasst:

- ein Maximalwertpunkt-Bestimmungsmodul (901), das ausgelegt ist zum, falls ein Effektivwert eines Nullsequenzstroms einer Stromleitung eines Stromnetzes größer oder gleich einem vorbestimmten Schwellwert ist, Bestimmen eines Maximalwertpunkts des Nullsequenzstroms,

wobei die Vorrichtung **gekennzeichnet ist durch**:

- ein Vorzeichenbestimmungsmodul (902), das ausgelegt ist zum Bestimmen des Vorzeichens des Maximalvariationsinkrements der Nullsequenzspannung entsprechend dem Maximalwertpunkt; und
- ein Vergleichsmodul (903), das ausgelegt ist zum Vergleichen des Vorzeichens des Maximalvariationsinkrements mit dem Vorzeichen des Nullsequenzstroms bei dem Maximalwertpunkt und, auf Basis des Vergleichsergebnisses, Bestimmen, ob sich der intermittierende Erdungsfehler in der Stromleitung befindet;

wobei das Vergleichsmodul ausgelegt ist zum Bestimmen der Richtung des intermittierenden Erdungsfehlers als Vorwärts, falls sich der intermittierende Erdungsfehler in der Stromleitung befindet, und ansonsten zum Bestimmen der Richtung als Rückwärts, falls sich der intermittierende Erdungsfehler nicht in der Stromleitung befindet.

**9.** Vorrichtung (900) zum Bestimmen einer Richtung eines intermittierenden Erdungsfehlers in einem Stromnetz nach Anspruch 8, **dadurch gekennzeichnet, dass**

- das Vergleichsmodul (903) spezifisch ausgelegt ist zum, falls das Vorzeichen des Maximalvariationsinkrements das gleiche ist wie das Vorzeichen des Nullsequenzstroms bei dem Maximalwertpunkt, Bestimmen, dass sich der intermittierende Erdungsfehler in der Stromleitung befindet, und, falls das Vorzeichen des Maximalvariationsinkrements dem Vorzeichen des Nullsequenzstroms an dem Maximalwertpunkt entgegengesetzt ist, Bestimmen, dass sich der intermittierende Erdungsfehler nicht in der Stromleitung befindet.

**10.** Vorrichtung (900) zum Bestimmen einer Richtung eines intermittierenden Erdungsfehlers in einem Stromnetz nach Anspruch 8 oder Anspruch 9, **dadurch gekennzeichnet, dass**

- das Maximalwertpunkt-Bestimmungsmodul (901) spezifisch ausgelegt ist zum Bestimmen von mehreren Maximalwertpunkten des Nullsequenzstroms in einem Suchbereich;
- das Vergleichsmodul (903) spezifisch ausgelegt ist zum, falls etwaige Vorzeichen der Maximalvariationsinkremente die gleichen sind wie die Vorzeichen der Nullsequenzströme bei den Maximalwertpunkten und die Anzahl der gleichen Vorzeichen einer ersten voreingestellten Regel genügt, Bestimmen, dass sich der intermittierende Erdungsfehler in der Stromleitung befindet, und falls etwaige Vorzeichen der Maximalvariationsinkremente den Vorzeichen der Nullsequenzströme an den Maximalwertpunkten entgegengesetzt sind und die Anzahl von entgegengesetzten Vorzeichen einer zweiten voreingestellten Regel genügt, Bestimmen, dass sich der intermittierende Erdungsfehler nicht in der Stromleitung befindet;

- bevorzugt umfasst die erste voreingestellte Regel: die Vorzeichen von M aufeinander folgenden Maximalvariationsinkrementen sind die gleichen wie die Vorzeichen der Nullsequenzströme an entsprechenden Maximalwertpunkten, wobei M eine ganze Zahl größer oder gleich 2 ist;

- bevorzugt umfasst die zweite voreingestellte Regel: die Vorzeichen von N aufeinanderfolgenden Maximalvariationsinkrementen sind den Vorzeichen der Nullsequenzströme an einem entsprechenden Maximalwertpunkt entgegengesetzt, wobei N eine ganze Zahl größer oder gleich 2 ist.

**11.** Vorrichtung (900) zum Bestimmen einer Richtung eines intermittierenden Erdungsfehlers in einem Stromnetz nach einem der Ansprüche 8 bis 10, **dadurch gekennzeichnet, dass**

- das Maximalwertpunkt-Bestimmungsmodul (901) weiter ausgelegt ist zum, bevor das Vergleichsmodul (903) das Vorzeichen des Maximalvariationsinkrements mit dem Vorzeichen des Nullsequenzstroms bei dem Maximalwertpunkt vergleicht, Bestimmen einer Zeitintervalldifferenz zwischen zwei benachbarten Maximalwertpunkten, und falls die Zeitintervalldifferenz kleiner ist als ein vorbestimmter Intervalldifferenzschwellwert, Verwerfen des letzteren der beiden benachbarten Maximalwertpunkte.

**12.** Vorrichtung (900) zum Bestimmen einer Richtung eines intermittierenden Erdungsfehlers in einem Stromnetz nach einem der Ansprüche 8 bis 11, **dadurch gekennzeichnet, dass**

- das Maximalwertpunkt-Bestimmungsmodul (901) ausgelegt ist zum, von dem Anfangspunkt eines Zyklus der Zeit, bei der der Effektivwert des Nullsequenzstroms der Stromleitung größer ist als der vorbestimmte Schwellwert, Bestimmen des Anstiegsanfangspunkts des Nullsequenzstroms; Bestimmen des Spitzenwerts des Nullsequenzstroms aus dem Anstiegsanfangspunkt des Nullsequenzstroms; und Bestimmen eines aktuellen Punkts entsprechend dem Spitzenwert als dem Maximalwertpunkt;

- bevorzugt ist das Maximalwertpunkt-Bestimmungsmodul (901) ausgelegt zum Bestimmen, ob der Nullsequenzstrom der Stromleitung einen ersten vorbestimmten Zustand erfüllt, und falls ja, Bestimmen, dass der Nullsequenzstrom der Stromleitung ein Anstiegsanfangspunkt ist;

- bevorzugt umfasst der erste vorbestimmte Zustand: ein abgetasteter Wert des Nullsequenzstroms ist größer als das Produkt aus dem Effektivwert und einem ersten vorbestimmten Faktor, und der aktuelle Wert des Nullsequenzstroms ist größer als das Produkt aus einem sekundären aktuellen Nennwert des Stromnetzes und einem zweiten vorbestimmten Faktor, wobei der erste vorbestimmte Faktor größer als 1 ist und der zweite vorbestimmte Faktor kleiner als 1 ist;

- besonders bevorzugt beträgt der erste vorbestimmte Faktor 2 und der zweite vorbestimmte Faktor 5.

**13.** Vorrichtung (900) zum Bestimmen einer Richtung eines intermittierenden Erdungsfehlers in einem Stromnetz nach einem der Ansprüche 8 bis 12, **dadurch gekennzeichnet, dass**

- das Vorzeichenbestimmungsmodul (902) ausgelegt ist zum Erhalten einer ersten Erste-Ableitungsfunktion der Nullsequenzspannung und Zeit; Erhalten einer zweiten Erste-Ableitungsfunktion der Nullsequenzspannung und Zeit des vorausgegangenen Zyklus; Bestimmen einer Differenzfunktion zwischen der ersten Erste-Ableitungsfunktion und der zweiten Erste-Ableitungsfunktion; und innerhalb eines vorbestimmten Zeitbereichs des Maximalwertpunkts, Bestimmen des Maximalwertpunkts des Betrags der Differenzfunktion und Bestimmen des Vorzeichens des Differenzfunktionswerts bei dem Maximalwertpunkt als das Vorzeichen des Maximalvariationsinkrements.

**14.** Vorrichtung (900) zum Bestimmen einer Richtung eines intermittierenden Erdungsfehlers in einem Stromnetz nach einem der Ansprüche 8 bis 12, **dadurch gekennzeichnet, dass**

- das Vergleichsmodul (903) weiter ausgelegt ist zum, nachdem das Vorzeichenbestimmungsmodul (902) das Vorzeichen des Maximalvariationsinkrements bestimmt, und vor dem Vergleichen des Vorzeichens des Maximalvariationsinkrements mit dem Vorzeichen des Nullsequenzstroms bei dem Maximalwertpunkt, Bestimmen, ob der Betrag des Maximalvariationsinkrements größer oder gleich einem vorbestimmten Variationsinkrementschwellwert ist, und falls nein, Verwerfen des Maximalvariationsinkrements und Bestimmen, dass die Richtung des intermittierenden Erdungsfehlers unbestimmt ist, oder

- das Vergleichsmodul (903) weiter ausgelegt ist zum, nachdem das Vorzeichen des Maximalvariationsinkrements bestimmt ist, und vor dem Vergleichen des Vorzeichens des Maximalvariationsinkrements mit dem Vorzeichen des Nullsequenzstroms bei dem Maximalwertpunkt, Bestimmen, ob der Betrag des Maximalvariationsinkrements größer oder gleich einem vorbestimmten Variationsinkrementschwellwert ist, und falls ja, Vergleichen des Vorzeichens des Maximalvariationsinkrements mit dem Vorzeichen des Nullsequenzstroms bei dem Maximalwertpunkt; bevorzugt beträgt der Variationsinkrementschwellwert A;

$$A = x\% * U_{nenn};$$

wobei $U_{nenn}$ den sekundären Nennspannungswert des Stromnetzes angibt; x eine vorbestimmte Konstante ist; und x bevorzugt 3 beträgt.

15. Vorrichtung (1000) zum Bestimmen einer Richtung eines intermittierenden Erdungsfehlers in einem Stromnetz, **dadurch gekennzeichnet, dass** die Vorrichtung umfasst: einen Prozessor (1001) und einen Speicher (1002); wobei der Speicher (1002) eine Applikation speichert, die durch den Prozessor (1001) ausführbar ist, um zu bewirken, dass der Prozessor (1001) die Schritte des Verfahrens zum Bestimmen einer Richtung eines intermittierenden Erdungsfehlers in einem Stromnetz nach einem der Ansprüche 1 bis 7 durchführt.

16. Computerlesbares Ablagemedium, **dadurch gekennzeichnet, dass** es computerlesbare Anweisungen speichert zum Durchführen der Schritte des Verfahrens zum Bestimmen einer Richtung eines intermittierenden Erdungsfehlers in einem Stromnetz nach einem der Ansprüche 1 bis 7.


**Revendications**

1. Procédé de détermination d'un sens d'un défaut à la terre intermittent dans un réseau électrique, le procédé comprenant :

   - si une valeur efficace d'un courant homopolaire d'une ligne électrique du réseau électrique est supérieure ou égale à un seuil prédéterminé, la détermination d'un point de valeur maximale du courant homopolaire à une première étape (102, 204),

   le procédé étant **caractérisé par** les étapes suivantes :

   - la détermination d'un signe d'un incrément de variation maximal de la tension homopolaire correspondant au point de valeur maximale à une deuxième étape (104, 206) ; et
   - la comparaison du signe de l'incrément de variation maximal au signe du courant homopolaire au point de valeur maximale à une troisième étape (106, 208) et, sur la base du résultat de comparaison, la détermination si le défaut à la terre intermittent se situe ou non dans la ligne électrique,
   - le sens du défaut à la terre intermittent étant déterminé comme un sens direct si le défaut à la terre intermittent se situe dans la ligne électrique et étant, sinon, déterminé comme un sens inverse si le défaut à la terre intermittent ne se situe pas dans la ligne électrique.

2. Procédé de détermination d'un sens d'un défaut à la terre intermittent dans un réseau électrique selon la revendication 1, **caractérisé en ce que**

   - ladite comparaison du signe de l'incrément de variation maximal au signe du courant homopolaire au point de valeur maximale à la troisième étape (106, 208) et, sur la base du résultat de comparaison, la détermination si le défaut à la terre intermittent se situe ou non dans la ligne électrique comprennent : si le signe de l'incrément de variation maximal est le même que le signe du courant homopolaire au point de valeur maximale, la détermination que le défaut à la terre intermittent se situe dans la ligne électrique ; et, si le signe de l'incrément de variation maximal est opposé au signe du courant homopolaire au point de valeur maximale, la détermination que le défaut à la terre intermittent ne se situe pas dans la ligne électrique.

3. Procédé de détermination d'un sens d'un défaut à la terre intermittent dans un réseau électrique selon la revendication 1 ou 2, **caractérisé en ce que**

   - ladite détermination du point de valeur maximale du courant homopolaire à la première étape (102, 204) comprend : la détermination d'une pluralité de points de valeur maximale du courant homopolaire dans une région de recherche ;

- ladite détermination du signe de l'incrément de variation maximal de la tension homopolaire correspondant au point de valeur maximale à la deuxième étape (104, 206) comprend : la détermination des signes de chaque incrément de variation maximal de la pluralité de tensions homopolaires correspondant à la pluralité de points de valeur maximale ;

- ladite comparaison du signe de l'incrément de variation maximal au signe du courant homopolaire au point de valeur maximale à la troisième étape (106, 208) et, sur la base du résultat de comparaison, la détermination si le défaut à la terre intermittent se situe ou non dans la ligne électrique comprennent : si des signes quelconques d'incréments de variation maximaux sont les mêmes que les signes des courants homopolaires aux points de valeur maximale et le nombre des mêmes signes satisfait à une première règle prédéfinie, la détermination que le défaut à la terre intermittent se situe dans la ligne électrique ; et, si des signes quelconques des incréments de variation maximaux sont opposés aux signes des courants homopolaires aux points de valeur maximale et le nombre de signes opposés satisfait à une deuxième règle prédéfinie, la détermination que le défaut à la terre intermittent ne se situe pas dans la ligne électrique ;

- de préférence, la première règle prédéfinie comprend : les signes de M incréments de variation maximaux consécutifs sont les mêmes que les signes des courants homopolaires à des points de valeur maximale correspondants, M étant un entier supérieur ou égal à 2 ;

- de préférence, la deuxième règle prédéfinie comprend : les signes de N incréments de variation maximaux consécutifs sont opposés aux signes des courants homopolaires à un point de valeur maximale correspondant, N étant un entier supérieur ou égal à 2.

4. Procédé de détermination d'un sens d'un défaut à la terre intermittent dans un réseau électrique selon l'une quelconque des revendications 1 à 3, **caractérisé en ce que**

- avant la comparaison du signe de l'incrément de variation maximal au signe du courant homopolaire au point de valeur maximale à la troisième étape (106, 208), le procédé comprend en outre, à la première étape (102, 204) :

- la détermination d'une différence d'intervalles de temps entre deux points de valeur maximale adjacents et, lorsque la différence d'intervalles de temps est inférieure à un seuil de différence d'intervalles prédéterminé, la mise à l'écart du dernier des deux points de valeur maximale adjacents à une première étape intermédiaire (205).

5. Procédé de détermination d'un sens d'un défaut à la terre intermittent dans un réseau électrique selon l'une quelconque des revendications 1 à 4, **caractérisé en ce que** : ladite détermination du point de valeur maximale du courant homopolaire à la première étape (102, 204) comprend :

- à partir du point de départ d'un cycle à l'instant où la valeur efficace du courant homopolaire de la ligne électrique est supérieure au seuil prédéterminé, la détermination du point de départ de montée du courant homopolaire à une deuxième étape intermédiaire (203) ;

- la détermination de la valeur de crête du courant homopolaire à partir du point de départ de montée du courant homopolaire à la deuxième étape intermédiaire (203) ;

- la détermination, comme point de valeur maximale à la première étape (102, 204), d'un point actuel correspondant à la valeur de crête ;

- de préférence, ladite détermination du point de départ en montée du courant homopolaire à la deuxième étape intermédiaire (203) comprend : la détermination si le courant homopolaire de la ligne électrique satisfait ou non à une première condition prédéterminée et, dans l'affirmative, la détermination que le courant homopolaire de la ligne électrique est le point de départ de montée ;

- de préférence, la première condition prédéterminée comprend : une valeur échantillonnée du courant homopolaire est supérieure au produit de la valeur efficace et d'un premier facteur prédéterminé, et la valeur actuelle du courant homopolaire est supérieure au produit d'une valeur de courant secondaire nominale du réseau électrique et d'un deuxième facteur prédéterminé, le premier facteur prédéterminé étant supérieur à 1 et le deuxième facteur prédéterminé étant inférieur à 1 ;

- de préférence encore, le premier facteur prédéterminé vaut 2 et le deuxième facteur prédéterminé vaut 5 %.

6. Procédé de détermination d'un sens d'un défaut à la terre intermittent dans un réseau électrique selon l'une quelconque des revendications 1 à 5, **caractérisé en ce que** : ladite détermination du signe de l'incrément de variation maximal de la tension homopolaire correspondant au point de valeur maximale à la deuxième étape (104, 206) comprend :

- l'obtention d'une première fonction dérivée première de la tension homopolaire et du temps ;
- l'obtention d'une deuxième fonction dérivée première de la tension homopolaire et du temps du cycle précédent ;
- la détermination d'une fonction différence entre la première fonction dérivée première et la deuxième fonction dérivée première ; et
- au sein d'une région temporelle prédéterminée du point de valeur maximale, la détermination d'un point de valeur maximale de la valeur absolue de la fonction différence, et la détermination, comme signe de l'incrément de variation maximal, du signe de la valeur de la fonction différence au point de valeur maximale.

7. Procédé de détermination d'un sens d'un défaut à la terre intermittent dans un réseau électrique selon l'une quelconque des revendications 1 à 6, **caractérisé en ce que** : après la détermination du signe de l'incrément de variation maximal à l'étape (104, 206), et avant la comparaison du signe de l'incrément de variation maximal au signe du courant homopolaire au point de valeur maximale à la troisième étape (106, 208), le procédé comprend en outre :

- la détermination si la valeur absolue de l'incrément de variation maximal est supérieure ou égale ou non à un seuil d'incrément de variation prédéterminé et, dans la négative, la mise à l'écart de l'incrément de variation maximal et la détermination qu'un sens du défaut à la terre intermittent est indéterminé, ou
- la détermination si la valeur absolue de l'incrément de variation maximal est supérieure ou égale ou non à un seuil d'incrément de variation prédéterminé à une troisième étape intermédiaire (207) et, dans l'affirmative, la comparaison du signe de l'incrément de variation maximal au signe du courant homopolaire au point de valeur maximale à la troisième étape (106 ; 208) ; de préférence, le seuil d'incrément de variation vaut A ;

$$A = x\% * U_{rated} \ ;$$

$U_{rated}$ indiquant la valeur de tension nominale secondaire du réseau électrique ; x représentant une constante prédéterminée ;
x valant de préférence 3.

8. Appareil (900) de détermination d'un sens d'un défaut à la terre intermittent dans un réseau électrique, l'appareil comprenant :

- un module de détermination de point de valeur maximale (901), configuré pour, si une valeur efficace d'un courant homopolaire d'une ligne électrique d'un réseau électrique est supérieure ou égale à un seuil prédéterminé, déterminer un point de valeur maximale du courant homopolaire,

l'appareil étant **caractérisé par** :

- un module de détermination de signe (902), configuré pour déterminer le signe de l'incrément de variation maximal de la tension homopolaire correspondant au point de valeur maximale ; et
- un module de comparaison (903), configuré pour comparer le signe de l'incrément de variation maximal au signe du courant homopolaire au point de valeur maximale et, sur la base du résultat de comparaison, déterminer si le défaut à la terre intermittent se situe ou non dans la ligne électrique ;

le module de comparaison étant configuré pour déterminer le sens du défaut à la terre intermittent comme un sens direct si le défaut à la terre intermittent se situe dans la ligne électrique et, sinon, pour déterminer le sens comme un sens inverse si le défaut à la terre intermittent ne se situe pas dans la ligne électrique.

9. Appareil (900) de détermination d'un sens d'un défaut à la terre intermittent dans un réseau électrique selon la revendication 8, **caractérisé en ce que**

- le module de comparaison (903) est plus particulièrement configuré pour, si le signe de l'incrément de variation maximal est le même que le signe du courant homopolaire au point de valeur maximale, déterminer que le défaut à la terre intermittent se situe dans la ligne électrique et, si le signe de l'incrément de variation maximal est opposé au signe du courant homopolaire au point de valeur maximale, déterminer que le défaut à la terre intermittent ne se situe pas dans la ligne électrique.

**10.** Appareil (900) de détermination d'un sens d'un défaut à la terre intermittent dans un réseau électrique selon la revendication 8 ou 9, **caractérisé en ce que**

- le module de détermination de point de valeur maximale (901) est plus particulièrement configuré pour déterminer une pluralité de points de valeur maximale du courant homopolaire dans une région de recherche ;
- le module de comparaison (903) est plus particulièrement configuré pour, si des signes quelconques d'incréments de variation maximaux sont les mêmes que les signes des courants homopolaires aux points de valeur maximale et le nombre des mêmes signes satisfait à une première règle prédéfinie, déterminer que le défaut à la terre intermittent se situe dans la ligne électrique et, si des signes quelconques des incréments de variation maximaux sont opposés aux signes des courants homopolaires aux points de valeur maximale et le nombre de signes opposés satisfait à une deuxième règle prédéfinie, déterminer que le défaut à la terre intermittent ne se situe pas dans la ligne électrique ;
- de préférence, la première règle prédéfinie comprend : les signes de M incréments de variation maximaux consécutifs sont les mêmes que les signes des courants homopolaires aux points de valeur maximale correspondants, M étant un entier supérieur ou égal à 2 ;
- de préférence, la deuxième règle prédéfinie comprend : les signes de N incréments de variation maximaux consécutifs sont opposés aux signes des courants homopolaires aux points de valeur maximale correspondants, N étant un entier supérieur ou égal à 2.

**11.** Appareil (900) de détermination d'un sens d'un défaut à la terre intermittent dans un réseau électrique selon l'une quelconque des revendications 8 à 10, **caractérisé en ce que**

- le module de détermination de point de valeur maximale (901) est configuré en outre pour, avant que le module de comparaison (903) compare le signe de l'incrément de variation maximal au signe du courant homopolaire au point de valeur maximale, déterminer une différence d'intervalles de temps entre deux points de valeur maximale adjacents et, si la différence d'intervalles de temps est inférieure à un seuil de différence d'intervalles prédéterminé, mettre à l'écart le dernier des deux points de valeur maximale adjacents.

**12.** Appareil (900) de détermination d'un sens d'un défaut à la terre intermittent dans un réseau électrique selon l'une quelconque des revendications 8 à 11, **caractérisé en ce que**

- le module de détermination de point de valeur maximale (901) est configuré pour, à partir du point de départ d'un cycle à l'instant où la valeur efficace du courant homopolaire de la ligne électrique est supérieure au seuil prédéterminé, déterminer le point de départ de montée du courant homopolaire ; déterminer la valeur de crête du courant homopolaire à partir du point de départ de montée du courant homopolaire ; et déterminer, comme point de valeur maximale, un point actuel correspondant à la valeur de crête ;
- de préférence, le module de détermination de point de valeur maximale (901) est configuré pour déterminer si le courant homopolaire de la ligne électrique satisfait ou non à une première condition prédéterminée et, dans l'affirmative, déterminer que le courant homopolaire de la ligne électrique est un point de départ de montée ;
- de préférence, la première condition prédéterminée comprend : une valeur échantillonnée du courant homopolaire est supérieure au produit de la valeur efficace et d'un premier facteur prédéterminé, et la valeur actuelle du courant homopolaire est supérieure au produit d'une valeur de courant secondaire nominale du réseau électrique et d'un deuxième facteur prédéterminé, le premier facteur prédéterminé étant supérieur à 1 et le deuxième facteur prédéterminé étant inférieur à 1 ;
- de préférence encore, le premier facteur prédéterminé vaut 2 et le deuxième facteur prédéterminé vaut 5.

**13.** Appareil (900) de détermination d'un sens d'un défaut à la terre intermittent dans un réseau électrique selon l'une quelconque des revendications 8 à 12, **caractérisé en ce que**

- le module de détermination de signe (902) est configuré pour obtenir une première fonction dérivée première de la tension homopolaire et du temps ; obtenir une deuxième fonction dérivée première de la tension homopolaire et du temps du cycle précédent ; déterminer une fonction différence entre la première fonction dérivée première et la deuxième fonction dérivée première ; et, au sein d'une région temporelle prédéterminée du point de valeur maximale, déterminer le point de valeur maximale de la valeur absolue de la fonction différence, et déterminer, comme signe de l'incrément de variation maximal, le signe de la valeur de la fonction différence au point de valeur maximale.

**14.** Appareil (900) de détermination d'un sens d'un défaut à la terre intermittent dans un réseau électrique selon l'une quelconque des revendications 8 à 12, **caractérisé en ce que**

- le module de comparaison (903) est configuré en outre pour, après que le module de détermination de signe (902) a déterminé le signe de l'incrément de variation maximal et avant de comparer le signe de l'incrément de variation maximal au signe du courant homopolaire au point de valeur maximale, déterminer si la valeur absolue de l'incrément de variation maximal est supérieure ou égale ou non à un seuil d'incrément de variation prédéterminé et, dans la négative, mettre à l'écart l'incrément de variation maximal et déterminer que le sens du défaut à la terre intermittent est indéterminé ; ou
- le module de comparaison (903) est configuré en outre pour, après que le signe de l'incrément de variation maximal a été déterminé et avant de comparer le signe de l'incrément de variation maximal au signe du courant homopolaire au point de valeur maximale, déterminer si la valeur absolue de l'incrément de variation maximal est supérieure ou égale ou non à un seuil d'incrément de variation prédéterminé et, dans l'affirmative, comparer le signe de l'incrément de variation maximal au signe du courant homopolaire au point de valeur maximale ;

de préférence, le seuil d'incrément de variation vaut A ;

$$A = x\% * U_{rated} \; ;$$

$U_{rated}$ indiquant la valeur de tension nominale secondaire du réseau électrique ; x représentant une constante prédéterminée et x valant de préférence 3.

15. Appareil (1000) de détermination d'un sens d'un défaut à la terre intermittent dans un réseau électrique, l'appareil **caractérisé en ce qu'**il comprend : un processeur (1001) et une mémoire (1002) ;
la mémoire (1002) stockant une application exécutable par le processeur (1001) pour amener le processeur (1001) à réaliser les étapes du procédé de détermination d'un sens d'un défaut à la terre intermittent dans un réseau électrique selon l'une quelconque des revendications 1 à 7.

16. Support de stockage lisible par ordinateur, **caractérisé en ce qu'**il stocke des instructions lisibles par ordinateur pour réaliser les étapes du procédé de détermination d'un sens d'un défaut à la terre intermittent dans un réseau électrique selon l'une quelconque des revendications 1 à 7.

Drawings for Specification

```
┌─────────────────────────────────────────┐
│                                         │
│                  102                    │
│                                         │
└─────────────────────────────────────────┘
                     │
                     ▼
┌─────────────────────────────────────────┐
│                                         │
│                  104                    │
│                                         │
└─────────────────────────────────────────┘
                     │
                     ▼
┌─────────────────────────────────────────┐
│                                         │
│                  106                    │
│                                         │
└─────────────────────────────────────────┘
```

Fig. 1

Fig. 2

Fig. 3

Fig. 4

Fig. 5

Fig. 6

Fig. 7

Fig. 8

900

901

902

903

Fig. 9

1000

1001 ——— 1002

Fig. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012123708 A1
- US 2016061873 A1

- US 2018011135 A1